# EUROPEAN PATENT SPECIFICATION

(11) **EP 0 866 506 B1**
(45) Date of publication and mention of the grant of the patent: **03.12.2008**
(21) Application number: 96933617.1
(22) Date of filing: 09.10.1996
(51) Int. Cl.: H01L 31/042, H01L 31/062, H01L 31/07, H01L 31/102, H01L 33/00, C25B 11/00, G09F 9/33, H01L 31/0352, H01L 27/15

(54) **SEMICONDUCTOR DEVICE**
HALBLEITERVORRICHTUNG
DISPOSITIF A SEMI-CONDUCTEURS

(43) Date of publication of application: 23.09.1998
(60) Divisional application: 07018093.0
(73) Proprietor: Nakata, Josuke, Kyoto 610-1102 (JP)
(72) Inventor: Nakata, Josuke, Kyoto 610-1102 (JP)
(74) Representative: Price, Nigel John King
(86) International application number: PCT/JP1996/002948
(87) International publication number: WO 1998/015983

(56) References cited:
- JP-A- 3 029 685
- JP-A- 5 036 997
- JP-A- 5 053 511
- JP-A- 6 302 853
- JP-A- 8 064 860
- JP-A- 8 125 210
- JP-A- 50 124 586
- JP-A- 50 137 488
- JP-A- 52 017 229
- JP-A- 61 220 482
- JP-U- 53 043 885
- JP-U- 60 041 063
- US-A- 2 904 613
- US-A- 3 350 775
- US-A- 3 411 952
- US-A- 3 921 026
- US-A- 4 021 323
- US-A- 4 037 241
- US-A- 4 643 817
- US-A- 5 469 020
- WOLF M.: 'Limitations and Possibilities for Improvement of Photovoltaic Solar Energy Converters: Part I: Considerations for Earth's Surface Operation' PROCEEDINGS OF THE IRE vol. 46, no. 7, 1960, pages 1246 - 1263, XP011156891
- SAHAI R. ET AL: 'High efficiency AlGaAs/GaAs concentrator solar cell development' 13TH IEEE PHOTOVOLTAIC SPECIALISTS CONF. 1978, pages 946 - 952, XP003021415
- EWAN J. ET AL: 'GaAs solar cells for high solar concentration applications' 13TH IEEE PHOTOVOLTAIC SPECIALISTS CONF. 1978, pages 941 - 945, XP003021416

## Description

The present invention relates to a semiconductor device comprising: bead-like, spherical semiconductor elements which incorporate a pn junction into a spherical crystal of a semiconductor and which have a pair of electrodes. The present invention further relates to a semiconductor device which can be used in semiconductor photocatalysts, solar batteries, display panels, or other various applications.

Semiconductor photocatalysts receive light from sunlight or the like and generate photovoltage. An electrochemical reaction is triggered by this photovoltage. Metal oxide semiconductors of titanium oxide (TiO2), strontium titanate (SrTiO2), or the like have been utilized as semiconductor photocatalysts. Titanium oxide is used as an electrode of a photochemical battery. A platinum electrode and a titanium oxide electrode are placed in water. When light is shined on the titanium oxide electrode, electrolysis of water is known to occur. Furthermore, there has been research on photocatalysts in which metals such as platinum are supported by a powder of a metal oxide semiconductor as well as research on electrodes comprising a thin film of titanium oxide on one side of a titanium plate.

When using a titanium oxide photocatalyst for the electrolysis of water by sunlight, only the portion of the spectrum which is approximately 410 nm or lower can be used from the entire light spectrum of sunlight. As a result, the photoelectric conversion efficiency is extremely low. The following are conditions which are necessary for a semiconductor photocatalyst or semiconductor electrode to be able to electrolyze water and for it to be able to adequately utilize the spectrum of sunlight: a photovoltage greater than or equal to the electrolytic voltage of water (theoretical value 1.23 V); a chemical stability so that there is no photodissociation of the semiconductor photocatalyst in the electrolyte solution, and the like.

Because the energy band gap of metal oxide semiconductors of titanium oxide or the like is large, it has the advantages of the electrolysis of water being possible and of not dissolving in the electrolyte solution. However, there is a problem because it does not function as a photocatalyst with the light spectrum when the wavelength is longer than approximately 410 nm. As a result, when conducting chemical reactions using sunlight for the photocatalytic action, only a small portion of the light spectrum of sunlight can be used, and the energy conversion efficiency becomes extremely poor. In order to increase catalytic efficiency, the photocatalyst of titanium oxide or the like is used in the form of a fine powder. However, this flows easily in the electrolyte solution, and as a result, recovery for the purpose of reuse is difficult. With regard to a photocatalyst in which a metal of platinum or the like is supported by a titanium oxide powder, because the anode site (site of oxidation reaction) and the cathode site (site of reduction reaction) exist close to each other, the probability of the reverse reaction is large. This is not very practical.

In USP 4,021,323, there is described a technology, wherein: small amounts of molten silicon solution are sprayed from a small nozzle which is placed on the upper end of a shot tower; silicon solution is allowed to free fall, and spherical crystals of silicon are created. However, with this technology, there is the possibility of impurities dissolving into the molten silicon solution from the nozzle. Furthermore, because there is a volume increase when molten silicon solution solidifies, and because solidification begins from the surface, the part which solidifies last will protrude towards the surface of the spherical crystal, and a protruding area is formed. A truly spherical sphere crystal is not formed. However, with the drop tube type experimental apparatus of NASA, because it is equipped with an electromagnetic levitation heating equipment, the material is allowed to melt and free fall.

In this USP, a pn junction is formed on the spherical crystal of silicon. There is also disclosed a solar cell array where there is formed a metal electrode film which is common to a plurality of these sphere crystals (micro photocells). Furthermore, these solar cell arrays are submerged in electrolyte solution. There is also disclosed a photochemical energy conversion device where electrolysis of a solution of hydroiodic acid and hydrobromic acid proceeds by the photovoltage provided by sunlight.

In the silicon solar cell array of this USP, there is not a pair of electrodes formed for each individual micro photocell, but there is a common electrode formed for a plurality of micro photocells. It is not possible to handle individual micro photocells independently. As a result, the micro photocells can not be dispersed in the electrolyte solution as individual semiconductor photocatalysts. Their installation positions can not be changed, nor can they be recovered and reused or washed. The limitations in its use as a semiconductor photocatalyst are extremely large. In addition, in this USP, there is no disclosure regarding the use of semiconductors with photocatalytic capability as electrodes, nor is there disclosure regarding the use of semiconductors which have photocatalytic function and which are selected by considering the reaction activity or reaction selectivity.

Because there is not a pair of electrodes on the surface of each of the microphotocells described above, a single or a plurality of spherical semiconductor elements having a pn junction can not be incorporated into a semiconductor device in such a way that they are independent cells or elements. Because the mode of electrical connection of the plurality of spherical semiconductor elements is fixed, it lacks in generalizability and is not practical.

In the prior art, a color display has been put into practical use. This color display incorporates a plurality of light emitting diodes which are of three types, emitting red light, blue light, or green light. Because each of the light emitting diode lamps can not have a detailed construction, it is not appropriate for small or light weight high resolution displays. In the case of a large size display, the number of parts is large, and it does not have an overall simple construction. The assembling cost is high. Using an integrated circuit technology, it is possible to produce light emitting diode elements which emit 3 colors of light, but the production costs become expensive. The interior integrated circuit becomes complicated, and defective products are more easily generated. This is not practical.

US 3,350,775 discloses a process of making a solar cell. One disclosed construction comprises a spherical body of semiconductor material with an ohmic contact on the bottom of the body and an annular ring ohmic contact group the middle, attached to the other conductivity type. Grid strips are used to lower the series resistance presented to the current carriers.

One aim of the present invention is to provide the following: a semiconductor device with a spherical semiconductor element which is bead-like, has photovoltaic capability, and has a pair of electrodes; a semiconductor photocatalyst which has excellent photoelectric conversion efficiency and which is practical and generalizable; a semiconductor photocatalyst with an increased electric potential between the oxidizing and reducing electrodes; a semiconductor photocatalyst in which the electric potential between the oxidizing and reducing electrodes can be adjusted freely; a semiconductor device as a solar battery which can receive incident light over a broad range and which has a high utilization efficiency of the semiconductor material; a semiconductor device as a solar battery which has a high degree of freedom in its electrical connections and which has a thin thickness; various semiconductor devices or the like as photodiodes.

A further aim of the present invention is to provide the following: a semiconductor device with a spherical semiconductor element which is bead-like, has light emitting capability through a pn junction, and has a pair of electrodes; a semiconductor device as a light emitting element which can emit light over a broad range and which has a high utilization efficiency of the semiconductor material; a semiconductor device as a light emitting element which has a high degree of freedom in its electrical connections and which has a thin thickness; semiconductor devices or the like as light emitting diodes, display panel, or various diodes.

A semiconductor device of the present invention is defined in claim 1.

When light is shined on the spherical semiconductor element, the photovoltage which is generated in the photovoltaic part appears on the pair of electrodes. A potential difference is generated between the pair of electrodes. This semiconductor device can be constructed from a single or a plurality of spherical semiconductor elements. It can also have other compositional elements as well. When this semiconductor device is immersed in an electrolyte solution, current flows from the positive electrode to the negative electrode, passing through the electrolyte solution. As a result, there is an oxidizing action in which electrons are absorbed at the positive electrode, and there is generated a reducing action at the negative electrode where electrons are given up. There is an electrochemical reaction corresponding to the electrolyte solution. In the case where the semiconductor device is maintained in atmospheric conditions or in a vacuum, when light is shined on the spherical semiconductor element, a potential difference is generated between the electrodes. Light energy is converted to electrical energy. As a result, this can be used in solar batteries or photodiodes.

Because the spherical semiconductor element has a pair of electrodes and is constructed as independent particles, this is advantageous for lining up a plurality of spherical semiconductor elements and for connecting them electrically. When creating a semiconductor device by incorporating a single or a plurality of spherical semiconductor elements to other compositional elements, there is a high degree of freedom, and it has excellent generalizability. The strength of the generated voltage can also be chosen freely.

When the electrodes are constructed in the claimed way, a plurality of spherical semiconductor elements can be aligned in a single row and a serial electrical connection can be created simply by connecting electrodes with opposing polarities. The connection can be maintained by the photovoltage. For the serial connection, the serial connection can be made easily by applying an external electric field while shining a light.

The photovoltaic part preferably comprises a diffusion layer which is formed near the surface of the spherical crystal and a pn junction.

If the spherical crystal is a p-type semiconductor, there is a n-type diffusion layer, if the spherical crystal is a n-type semiconductor, there is a p-type diffusion layer. The photovoltage is generated via the pn junction which is at the border between the diffusion layer and the semiconductor crystal which forms the spherical crystal. As a result, the voltage is high and has excellent stability. It is advantageous in terms of the photoelectric conversion efficiency.

The spherical semiconductor element can be a semiconductor photocatalyst, which, with the photovoltage generated when the photovoltaic part receives light, generates an electrochemical reaction between the electrodes and the electrolyte solution.

Examples of the electrochemical reaction include the electrolysis of water, electrolysis of methanol aqueous solution, electrolysis of hydriodic acid solution, or the electrolysis of various other electrolyte solutions. In this case, the semiconductor device can be constructed solely from a plurality of spherical semiconductor elements. Material with a catalytic function is preferred for the material of the electrode. Using reaction activity and reaction selectivity as a basis, material which is to be used for the electrode is selected on its relation with the reaction products. For example, for a hydrogen generating reducing electrode, Ni (nickel), Ru (ruthenium), Ir (iridium), or their oxides are preferred, but it is not limited to these. Appropriate material for a reducing electrode which generates methane is Pd (palladium), Rh (rhodium), but is not limited to these. When an electrode of one polarity is constructed with a metal oxide semiconductor which functions as a photocatalyst, the activating voltage for the electrochemical reaction can be low, and the energy conversion efficiency is increased.

The semiconductor device can comprise a plurality of spherical semiconductor elements. The semiconductor device is operated while several spherical semiconductor elements at a time are connected electrically in series via the photovoltage generated by the photovoltaic part of the spherical semiconductor elements which are in the electrolyte solution. In this case, the semiconductor device does not require compositional elements other than a plurality of spherical semiconductor elements. The plurality of bead-like spherical semiconductor elements can be used as semiconductor photocatalysts. Depending on the type of electrochemical reaction, the spherical semiconductor elements can be used each independently, or n of these (n = an integer of 2 or greater) can be connected in series, and a photovoltage of approximately n times can be generated. In this case, the plurality of spherical semiconductor elements can be dispersed in the electrolyte solution; the placement positions can be changed as appropriate; recovery and reuse is possible. As a result, there is a the degree of freedom in its usage, and there is excellent generalizability. Because the positive electrode and the negative electrode are separated, the reverse reaction is prevented. Because the spherical semiconductor can be illuminated from a light from broad range of incident angles, it is advantageous when using sunlight. Furthermore, spherical semiconductor elements have excellent mechanical strength.

The surface of the spherical crystal, other than at the electrodes, is preferably covered with an insulating coating which is light transparent and has anti-reflective properties. This insulating coating can be a coating of one layer, or it can be a coating of 2 layers. Electrical and chemical stability is maintained by the insulating action of the insulating coating. The rate of reflection of light is lowered due to the anti-reflective function of the insulating coating, and the efficiency is improved. The following materials can be used as material for the insulating coating: SiO2, Si3N4, Al2O3, Ta2O5, TiO2, MgF2, SnO2, or Nb2O5, or the like. However, the material for the insulating coating is to be selected in relation with the spherical crystal material.

The surface of the insulating coating can be covered with a light transparent coating which is connected to an electrode of one polarity; this coating is made of metal oxide semiconductor which has a photocatalytic capacity.

The electrochemical reaction can be accelerated by the photocatalytic capacity of this coating. Metal oxide semiconductors which have a photocatalytic capacity include: TiO2, SrTiO3, Fe2O3, PbxTi(1-x)O2, and the like. The energy band gap curves at the phase boundary surface where these metal oxide semiconductors are in contact with the electrolyte solution. The hole and the electrons separate, and the oxidation reaction or reduction reaction is accelerated.

The surface of an electrode of one polarity and a portion or the entire surface of the insulating coating can be covered with a light transparent electrode coating; this coating is made of metal oxide semiconductor which has a photocatalytic capacity. This electrode coating can accelerate the electrochemical reaction by its photocatalytic capacity. Furthermore, the electric potential between the oxidizing and reducing electrodes can be increased.

The spherical crystal described above can be constructed from a semiconductor of Si or SiGe, Group III-V compound semiconductor of GaAs or InP or the like, chalcopyrite-type semiconductor of CulnSe2 or the like.

The semiconductor device can comprise: a transparent case which has a storage cavity which stores a single spherical semiconductor element; a pair of external electrodes which is partially inserted into both sides of the storage cavity and hermetically seals the cavity; the pair of external electrodes being electrically connected to electrodes of each of the spherical semiconductor elements. This semiconductor device is appropriate for photodiodes. When light is shined from outside of the case, a potential difference is generated in the pair of external electrodes. Because the spherical semiconductor element is housed inside a transparent case, it is possible to detect incident light from the entire 360 degree range.

The semiconductor device can comprise: a semiconductor element array in which a plurality of the spherical semiconductor elements is electrically connected in series and is lined up in a single row; a transparent case which has a storage cavity which stores this semiconductor element array; a pair of external electrodes which is partially inserted onto both sides of the storage cavity of the case and hermetically seals it; the pair of electrodes being electrically connected to each of the electrodes of the spherical semiconductor elements which are on both ends of the semiconductor array. This semiconductor device is suitable for photodiode arrays or solar cell arrays. Because the semiconductor element array is housed inside a transparent case, it is possible to detect incident light from the entire 360 degree range. By adjusting the number of spherical semiconductor elements which are connected in series, the size of photovoltage can be adjusted appropriately.

In the casing described above, a plurality of storage cavities can be formed in parallel; a semiconductor element array can be placed in each storage cavity; and a pair of external electrodes can be placed on either end of each storage cavity. The overall semiconductor device is panel-like or sheet-like. It receives incident light from either side of the transparent case and converts it to voltage. The multi-row multi-column spherical semiconductor elements can reliably receive incident light even when there are large changes in the angle of incidence of the light. It is suited for solar battery panels. Furthermore, because a portion of the incident light exits from the opposite side by passing through the spherical semiconductor elements and the case, it can be a solar battery panel which also serves as window glass.

The semiconductor device can comprise: a semiconductor element array in which a plurality of the spherical semiconductor elements is electrically connected in series and is lined up in a single row; a pair of electrodes being electrically connected to each of the electrodes of the spherical semiconductor elements which are on both ends of the semiconductor array; and a transparent case member which covers the exterior of the semiconductor element array. The case member is preferably constructed from a synthetic resin material of silicone resin or the like. The semiconductor element array can be imbedded inside the case member.

A plurality of the semiconductor element arrays can be placed in parallel; the plurality of semiconductor element arrays can be stored in an imbedded state inside the case member; and a plurality of pairs of electrodes can be placed corresponding to the plurality of semiconductor element arrays. The case member is preferably constructed from a synthetic resin material of silicone resin or the like. Because the semiconductor element arrays are imbedded inside the case member, the incidence efficiency of the light is heightened.

Another semiconductor device of the present invention is defined in claim 14. When voltage is applied to the pair of electrodes of the spherical semiconductor element, the semiconductor device emits light at the pn junction as a function of the type of semiconductor spherical crystal and the type of dopants contained in the semiconductor. This principle of the light emission is the same as the principle for known light emitting diodes. The configuration of the light emitting mechanism is the same as in known light emitting diodes.

As a result, this semiconductor device is suited as a light emitting element However, it can also be used for various diodes or the like such as other rectifier diodes or the like. The type of semiconductor, the type of doping agent elements, the type of pn junction (in other words, the configuration of the spherical semiconductor element) can be set for the desired light emitting function or other function. The settings are based on known technology relating to light emitting diodes. The semiconductor device can be constructed from a single or a plurality of spherical semiconductor elements, and can also include other configuration elements. When using as a light emitting element, because light is emitted in the interior of the spherical semiconductor element, there are no limitations on the direction in which the light exits, and light can exit in all directions. The spherical semiconductor element has a pair of electrodes and is constructed as independent particles. As a result, this is advantageous for connecting resistance wires individually to each spherical semiconductor element. When making a semiconductor device which incorporates a single or a plurality of spherical semiconductor elements to other configuration elements, there is a high degree of freedom and excellent generalizability. The light emitting capability can also be set freely.

The surface of the spherical crystal, other than at the electrodes, can be covered with an insulating coating which is light transparent. The insulating coating can be a single layer coating, or a 2 layer coating. Electrical and chemical stability can be maintained by the insulating action of the insulating layer. The electrode with one polarity and the electrode with the other polarity are placed so that they are at least partially opposite each other with the center of the spherical crystal interposed between them.

When the electrodes are constructed in this way, a plurality of spherical semiconductor elements can be lined up in a single row. They can be electrically connected in a serial manner simply by having electrodes of different polarities in contact with each other.

A semiconductor device may comprise: a transparent case which has a storage cavity which stores one spherical semiconductor element; a pair of external electrodes which is partially inserted onto both ends of the storage cavity and which hermetically seals it; the pair of external electrodes being connected electrically to the electrodes of each of the spherical semiconductor elements.

This semiconductor device is suited for rectifier diodes and variable capacity diodes or the like. Voltage can be applied to the pair of electrodes of the spherical semiconductor element via the pair of external electrodes.

A semiconductor device may comprise: a semiconductor element array in which a plurality of the spherical semiconductor elements is electrically connected in series and is lined up in a single row; a transparent case which has a storage cavity which stores this semiconductor element array; a pair of external electrodes which is partially inserted onto both sides of the storage cavity of the case and hermetically seals it; the pair of electrodes being electrically connected to each of the electrodes of the spherical semiconductor elements which are on both ends of the semiconductor array. When voltage is applied to the pair of external electrodes, a plurality of spherical semiconductor elements of the semiconductor element array emit light. Therefore, this semiconductor device is suitable for light emitting diode arrays. Because the semiconductor element array is housed inside a transparent case, light can exit from the entire 360 degree range. By adjusting the number of spherical semiconductor elements which are connected in series, the light emitting capacity can be adjusted appropriately.

In the casing described above, a plurality of storage cavities can be formed in parallel; a semiconductor element array can be placed in each storage cavity; and a pair of external electrodes can be placed on either end of each storage cavity. The overall semiconductor device is panel-like or sheet-like. Although light exits from either side of the transparent case, light can be made to exit from only one side by forming a reflective coating on the other side. When light is emitted from a plurality of rows and a plurality of columns of the spherical semiconductor elements, it becomes a light emitting surface. It is suited for a light emitting surface device.

A semiconductor device may comprise: a semiconductor element array in which a plurality of the spherical semiconductor elements is electrically connected in series and is lined up in a single row; a pair of electrodes which is electrically connected to each of the electrodes of the spherical semiconductor elements which are on both ends of the semiconductor array; and a transparent case member which covers the exterior of the semiconductor element array. The case member is preferably constructed from a synthetic resin material of silicone resin or the like. The semiconductor element array can be imbedded inside the case member.

There can be a plurality of rows of semiconductor element arrays; this plurality of semiconductor element arrays are embedded in the transparent sheet-like case member described above; and there are then a plurality of pairs of electrodes which correspond to the plurality of semiconductor element arrays. The case member is preferably constructed from a synthetic resin material of silicone resin or the like. Because the semiconductor element array is imbedded inside the case member, the light exiting efficiency is heightened.

The present semiconductor device can be a device which has a light emitting function in which light is emitted by applying voltage to the spherical semiconductor elements.

The semiconductor device can be a device which functions as a light emitting display panel, wherein: a plurality of the spherical semiconductor elements are placed to make a matrix of a plurality of rows and a plurality of columns; these plurality of spherical semiconductor elements are housed in a case member which is transparent and panel-like; and light is emitted by selectively applying voltage to the pair of electrodes of each individual semiconductor elements. The overall semiconductor device can be panel-like. Although light exits from both sides of the transparent case, light can be made to exit from only one side by forming a reflective coating on the other side. In the case of a large size display panel, the diameter of the spherical semiconductor element can be of a size of several mm, but in the case of a small size display panel on the order of a CRT display or a liquid crystal display, the diameter of the spherical semiconductor element is on the order of 200-300 micrometer. Furthermore, in order to prevent the light leaving each spherical semiconductor element from leaking towards neighboring spherical semiconductor elements, it is preferable to form a fine separating wall which optically isolates the spherical semiconductor elements.

In the case of a monochromatic display panel, one type of spherical semiconductor element can be used. In the case of a color display panel, it is necessary to generate full color light by the synthesis of the three colors of red, green, and blue light. As a result the plurality of spherical semiconductor elements can comprise: a plurality of spherical semiconductor elements number 1 which is capable of generating red light; a plurality of spherical semiconductor elements number 2 which is capable of generating green light; and a plurality of spherical semiconductor elements number 3 which is capable of generating blue light. Spherical semiconductor elements numbers 1-3 can be alternated cyclically in the row direction of the matrix, and may also be alternated cyclically in the column direction of the matrix.

Each spherical crystal in the spherical semiconductor elements numbers 1-3 can be n-type GaAs semiconductors. The diffusion layer on the spherical crystal can contain Zn as the p-type dopant. On the surface of the spherical crystal of-the spherical semiconductor element number 1, there can be formed a coating which contains a phosphor which converts infrared light to red light; on the surface of the spherical crystal of the spherical semiconductor element number 2, there can be formed a coating which contains a phosphor which converts infrared light to green light; and on the surface of the spherical crystal of the spherical semiconductor element number 3, there can be formed a coating which contains a phosphor which converts infrared light to blue light In this manner, except for the coating which contains the phosphor, spherical semiconductor elements numbers 1-3 can be constructed with the same configuration, and they can be driven by the same driving voltage.

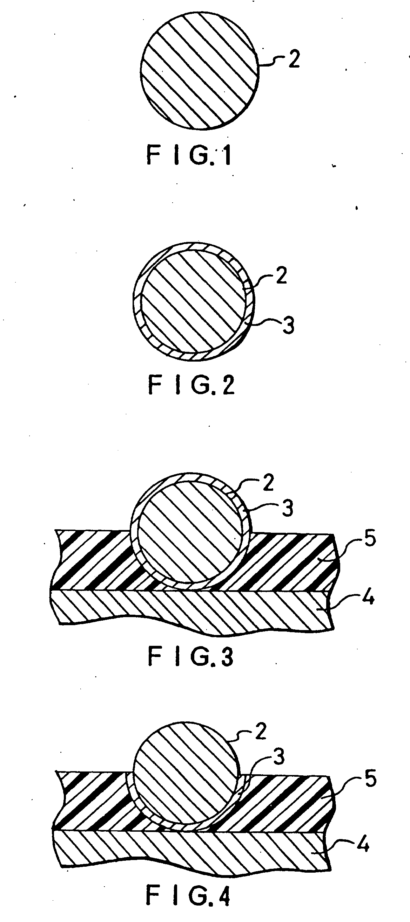

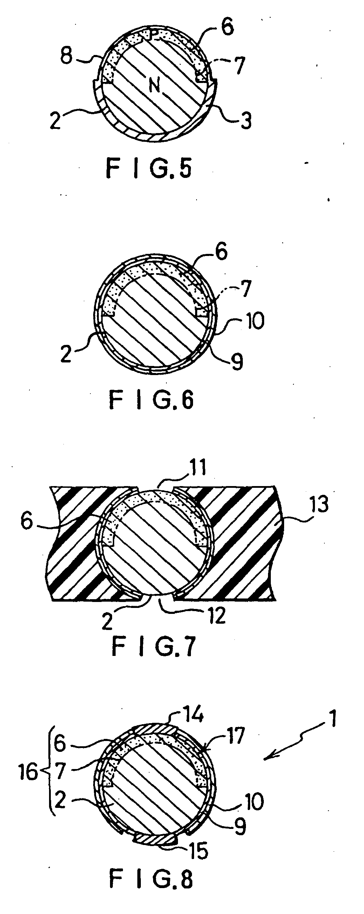

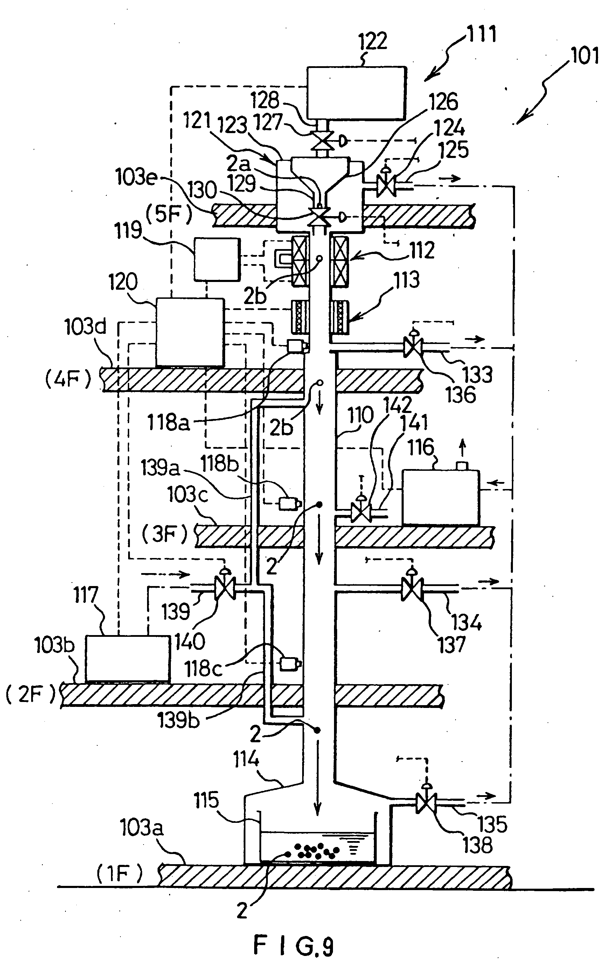

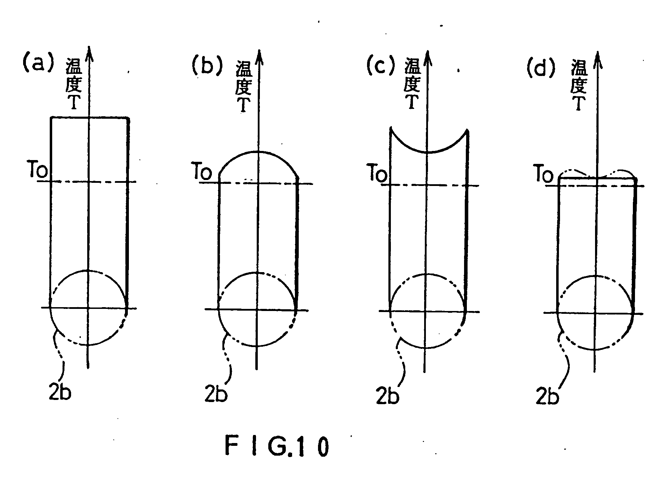

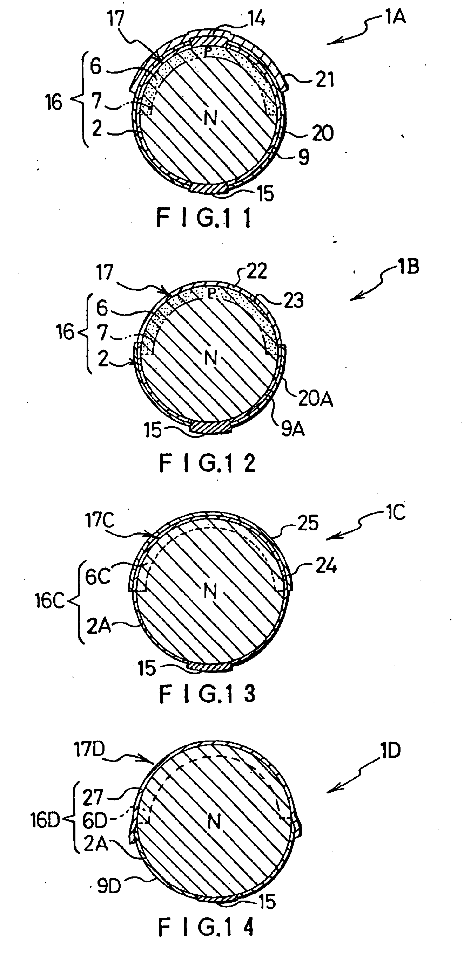

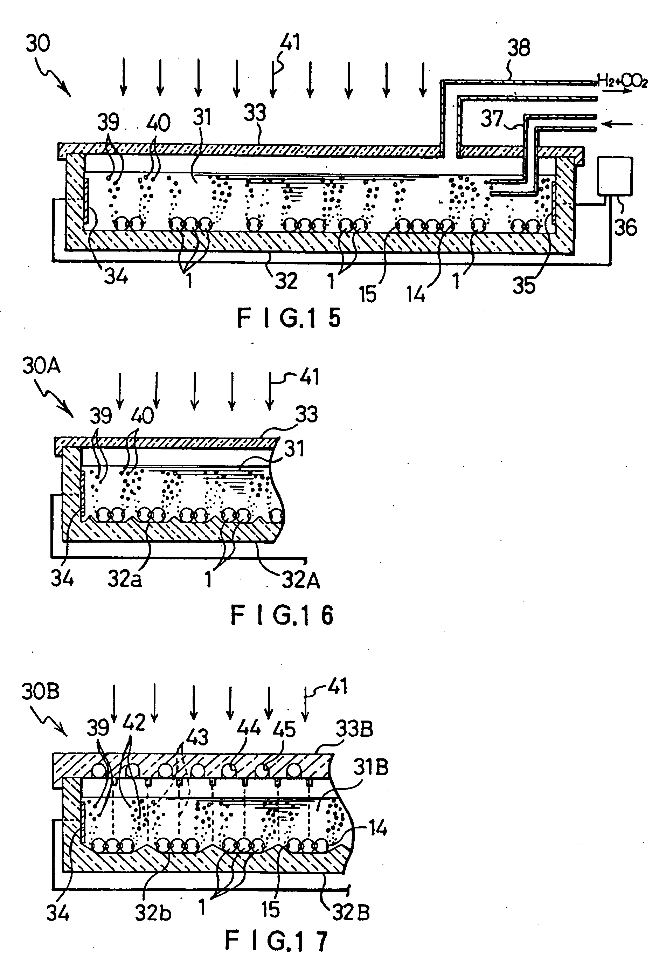

Figures 1-11 and 15-17 show the first embodiment of the present invention. Figures 12-14 show unclaimed examples. Figure 1 is a cross-sectional diagram of a spherical crystal of a semiconductor. Figure 2 is a cross-sectional diagram of the spherical crystal covered with a coating. Figure 3 is a cross-sectional diagram in which the spherical crystal is covered with a coating and masked with a resin film. Figure 4 is a cross-sectional diagram in which etching has been done after masking. Figure 5 is a cross-sectional diagram in which a p-type diffusion layer is formed on the spherical crystal. Figure 6 is a cross-sectional diagram in which there is a coating formed on the surface of the spherical crystal. Figure 7 is a cross-sectional diagram in which there is a light sensitive resin film mask, and an opening is formed. Figure 8 is a cross-sectional diagram of a semiconductor photocatalyst. Figure 9 is a block diagram of a semiconductor spherical crystal manufacturing device. Figure 10(a) is a temperature distribution diagram of a molten solution immediately after melting. Figure 10(b) is a temperature distribution diagram of the molten solution immediately after the commencement of dropping. Figure 10(c) is a temperature distribution diagram of the molten solution immediately after heating with an infrared heater. Figure 10(d) is a temperature distribution diagram of the molten solution immediately after solidification has begun. Figure 11 is a cross-sectional diagram of a modification mode 1 of the semiconductor photocatalyst. Figure 12 is a cross-sectional diagram of an unclaimed example. Figure 13 is a cross-sectinal diagram of another unclaimed example. Figure 14 is a cross-sectional diagram of a further unclaimed example. Figure 15 is a cross-sectional diagram of an electrolytic device with a semiconductor photocatalyst. Figure 16 is a schematic cross-sectional diagram of an electrolytic device with a semiconductor photocatalyst which has been partially modified. Figure 17 is a schematic cross-sectional diagram of an electrolytic device with a semiconductor photocatalyst which has been partially modified.

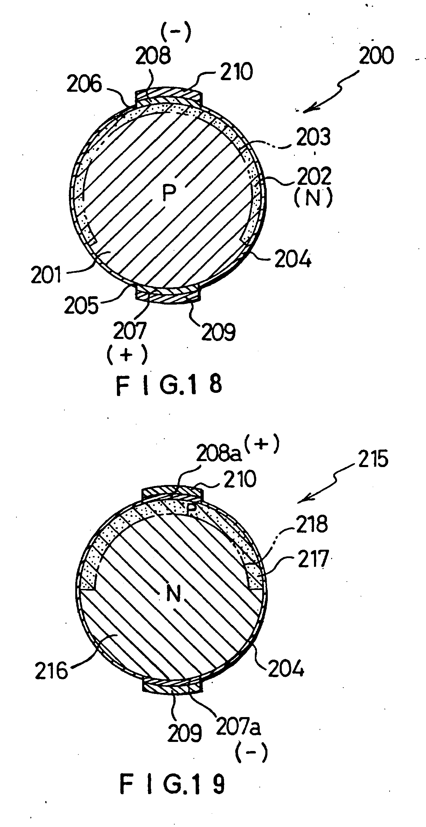

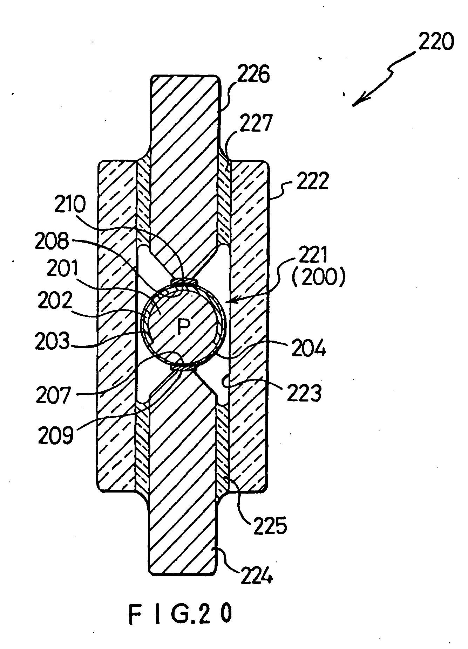

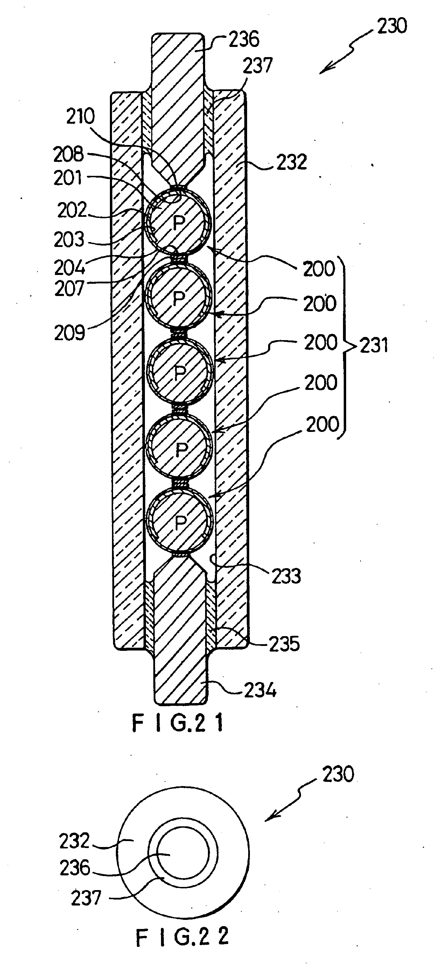

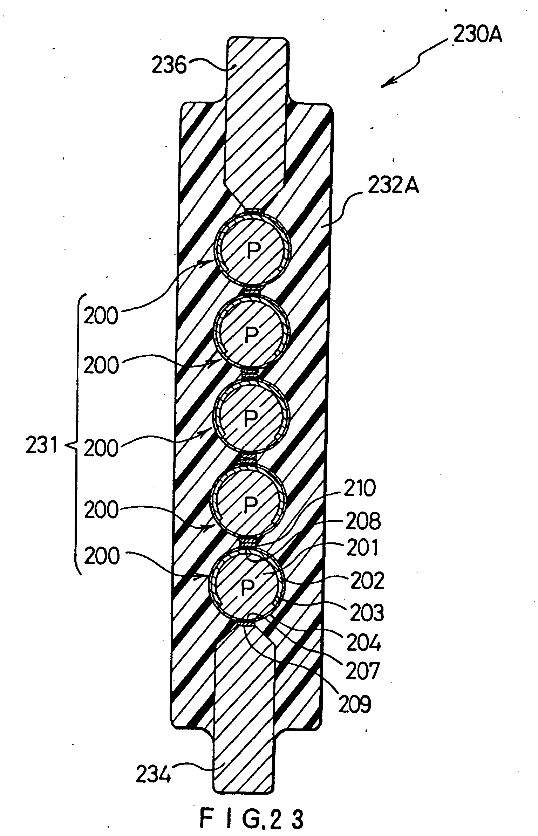

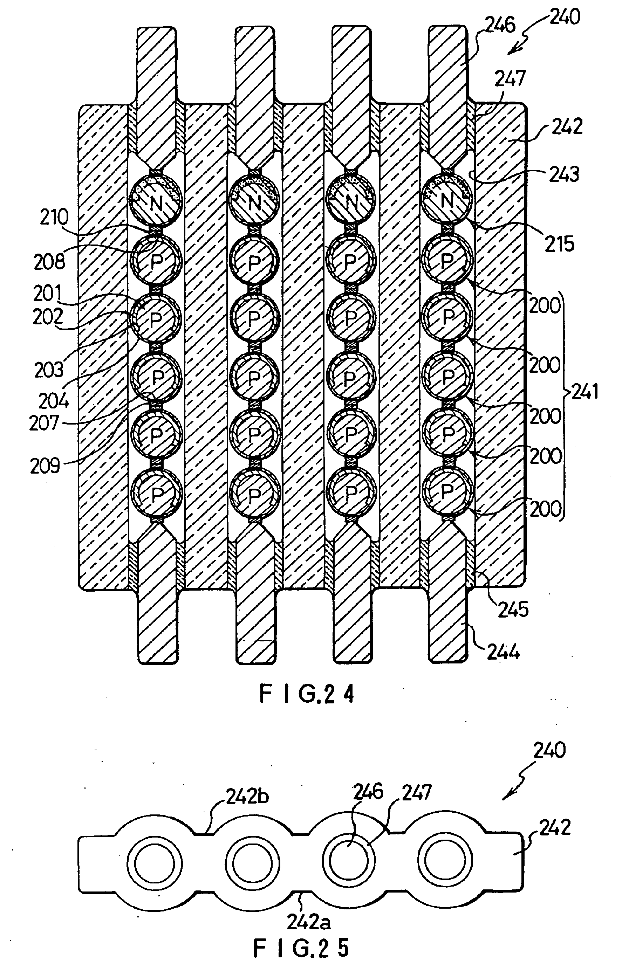

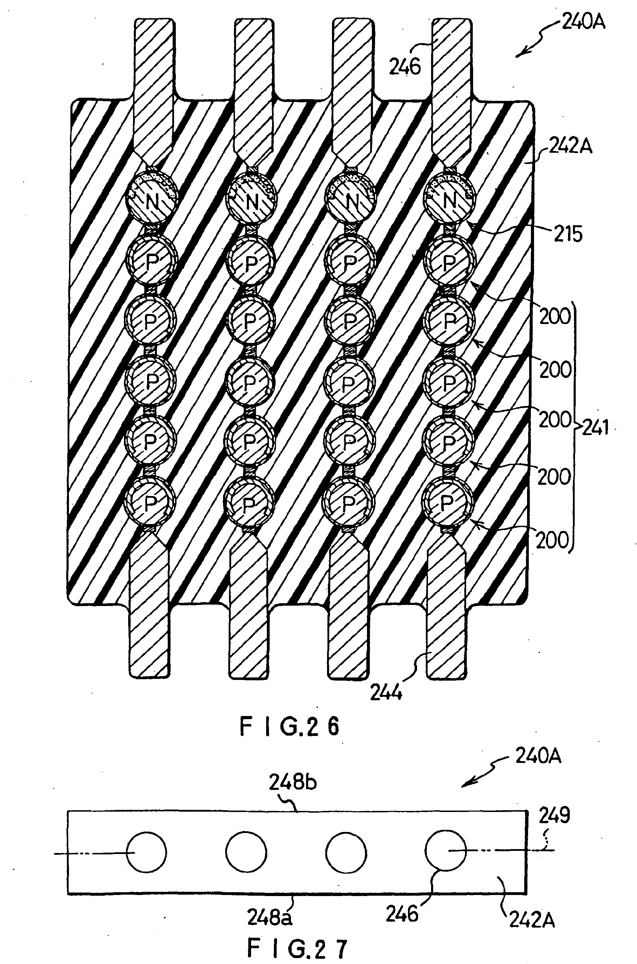

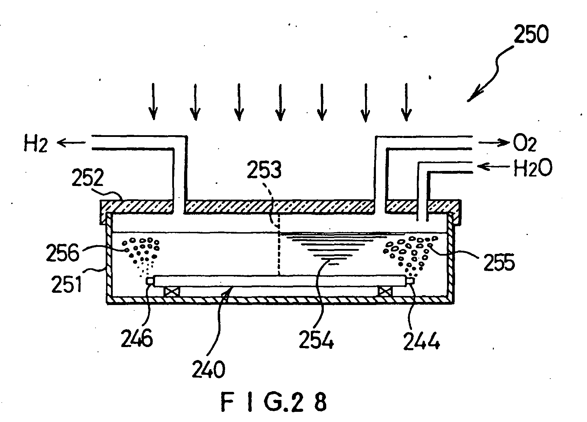

Figures 18-28 are diagrams of Embodiment 2 of the present invention. Figure 18 is a cross-sectional diagram of a solar cell. Figure 19 is a cross-sectional diagram of a rectifier diode of a modification mode 1. Figure 20 is a cross-sectional diagram of a photodiode of a modification mode 2. Figure 21 is a cross-sectional diagram of a solar battery device of a modification mode 3. Figure 22 is a plan view of the solar battery device of Figure 21. Figure 23 is a cross-sectional diagram of another solar battery device. Figure 24 is a cross-sectional diagram of a solar battery module of modification mode 3. Figure 25 is a plan view of the solar battery module of Figure 24. Figure 26 is a cross-sectional diagram of another solar battery module. Figure 27 is a plan view of the solar battery module in Figure 26. Figure 28 is a cross-sectional diagram of the electrolytic device which uses a solar battery module.

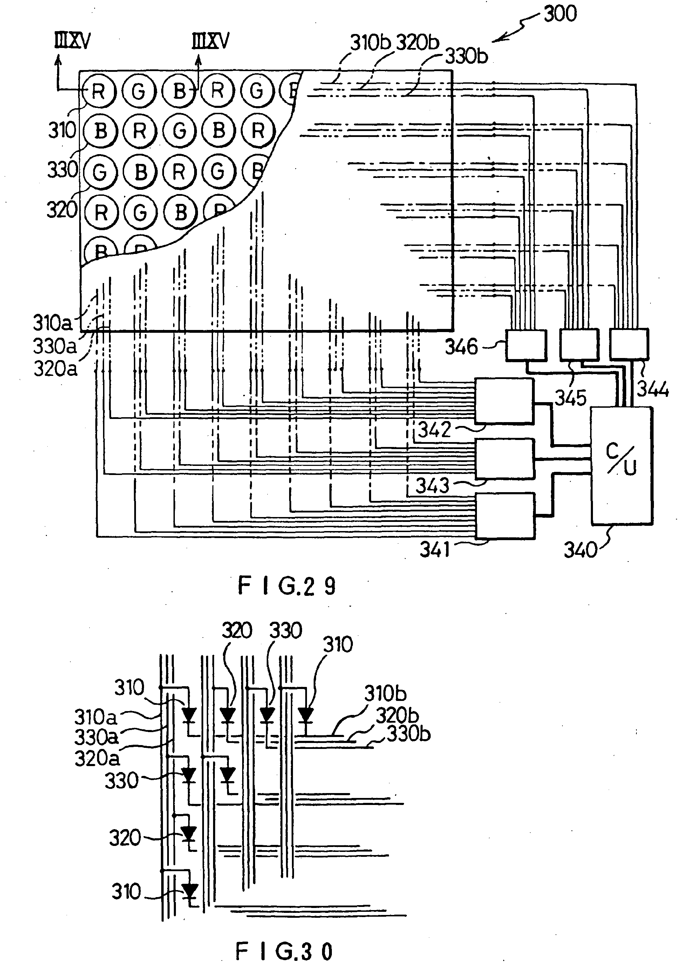

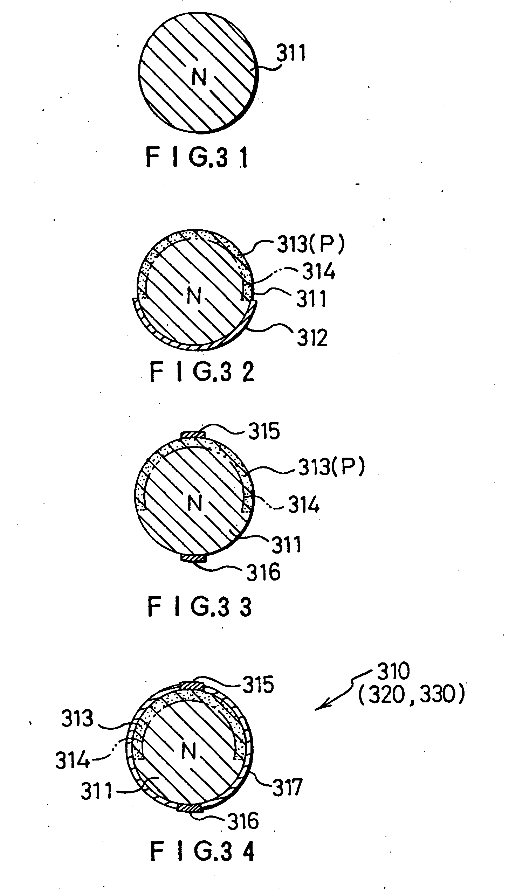

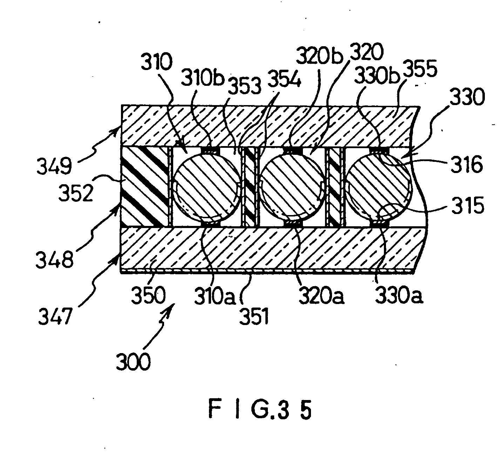

Figures 29-34 show Embodiment 3 of the present invention. Figure 29 is a block diagram of a display panel which incorporates light emitting diodes of 3 colors. Figure 30 is a schematic drawing of an electrical circuit of a display panel. Figure 31 is a cross-sectional diagram of a spherical crystal of a semiconductor. Figure 32 is a cross-sectional diagram of the spherical crystal which forms a pn junction with a p-type diffusion layer. Figure 33 is a cross-sectional diagram of a spherical crystal which has electrodes. Figure 34 is a cross-sectional diagram of a light-emitting diode. Figure 35 is a cross-sectional drawing of Figure 29 along the line IIIXV-IIIXV.

Referring to the drawings, the best mode for carrying out the present invention will be described below.

### EMBODIMENT 1 (Refer to Figures 1-11 and 15-17)

The semiconductor device of the present embodiment is constructed from an assemblage in which a plurality of units of semiconductor photocatalysts which are described below are assembled.

First, the configuration of the semiconductor photocatalyst will be described briefly.

Referring to Figure 8, a semiconductor photocatalyst 1 (corresponding to spherical semiconductor element) comprises: a spherical crystal 2 of a n-type silicon semiconductor; a p-type diffusion layer 6 which is formed on the surface portion of the upper half of spherical crystal 2 and which is contained in spherical crystal 2; a pair of electrodes 14, 15; a coating 9 of SiO2 (silicon oxide) which covers the surface of spherical crystal 2, except at the electrodes 14, 15; a coating 10 of TiO2 (titanium oxide) which is formed on the surface of coating 9 of SiO2. A photovoltaic part 16 which contains a pn junction 7 is formed on the surface of spherical crystal 2. A micro photocell 17 is constructed from spherical crystal 2 and photovoltaic part 16. While immersed in an electrolyte solution, the independent and bead-like semiconductor photocatalyst 1 triggers an electrochemical reaction via the photovoltage generated by micro photocell 17 with light which is supplied from the exterior.

Next, the configuration and manufacturing method of semiconductor photocatalyst 1 is explained.

Referring to Figure 1, step 1 is to produce spherical crystal 2 which is a spherical n-type silicon semiconductor. Spherical crystal 2 is formed into a perfect sphere using an n-type silicon semiconductor with a dopant concentration of approximately 1.5x10^16 cm^-3 and with a diameter of, for example, approximately 1.5mm. Spherical crystal 2 which is a perfect sphere can be manufactured by melting silicon semiconductor granules with an electromagnetic levitation heating equipment. Next, the suspension is terminated, and the silicon semiconductor is solidified while it is free falling inside a drop tube. By doing this, spherical crystal 2 with a smooth surface can be produced. Furthermore, the crystal structure can be improved as needed by heating to a temperature of 600-900 degrees C under an inert gas atmosphere and annealing. Referring to Figures 9, 10, step 1 of the manufacturing method of spherical crystal 2 will be described later.

Next, referring to Figure 2, in step 2, spherical crystal 2 is heated to approximately 1150 degrees C in an atmosphere which contains oxygen using a known method. A coating 3 of SiO2 (silicon oxide) of thickness 1 micrometer is formed over the entire surface of spherical crystal 2. Next, referring to Figure 3, in step 3, spherical crystal 2, on which there is formed coating 3, is placed on a support plate 4 which is made of glass, for example. A liquid-state resin film 5 which is an acid resistant synthetic resin and has a thickness of approximately the radius of spherical crystal 2 is formed on top of support plate 4. After covering the bottom half of spherical crystal 2 with resin film 5, resin film 5 is made solid.

Next, in step 4, using a diluted hydrofluoric acid solution, portions of spherical crystal 2 which are not covered by resin film 5 are etched. Coating 3 of SiO2 is dissolved and removed. Referring to Figure 4, the result is shown. Next, referring to Figure 5, in step 5, resin film 5 is dissolved using a solvent. Spherical crystal 2 is removed from support plate 4. The surface of spherical crystal 2 is rinsed with an appropriate cleaning solution. Next, doping element for the formation of a p-type diffusion layer 6 is diffused by heating on the surface of the upper half of spherical crystal 2 by a known method, and a p-type diffusion layer 6 is formed.

In this case, coating 3 covers the surface of the lower half of spherical crystal 2 and is used as a diffusion mask. P-type diffusion layer 6 is formed by heat diffusing B (boron) as a doping agent element. By the previously described heat diffusion, a coating 8 of SiO2 which is continuous with coating 3 is formed attached to the surface of p-type diffusion layer 6. As a result, a pn junction 7 between spherical crystal 2 and p-type diffusion layer 6 is formed at a depth of 0.5-0.8 micrometer from the surface of spherical crystal 2. When light from sunlight or the like is received from the exterior, pn junction 7 generates photovoltage by separating an excited carrier (electron and hole).

Next, in step 6, by etching with a diluted hydrofluoric acid solution, coating 3, 8 on the surface of spherical crystal 2 are removed. Next, referring to Figure 6, a coating 9 of SiO2 is formed on the surface of spherical crystal 2 which contains diffusion layer 6. This is done by the known art of physical vapor deposition (PVD) or chemical vapor deposition (CVD). Coating 9 is formed in order to make the surface of pn junction 7 passivate. A TiO2 (titanium oxide) coating 10 is formed on the surface of coating 9.

Coatings 9, 10 reduce the leak current on the surface of pn junction 7. Coatings 9, 10 improve the stability. They also reduce light reflection at the surface because of their differences in the index of refraction. Both coatings 9, 10 serve as both insulating films and passivation films. They protect pn junction 7 and make the surface passivate. They also function as anti-reflective films which prevent the reflection of light. TiO2 is a n-type semiconductor and functions as a photocatalyst. As a result, light from the incident light which is of wavelength of approximately 420 nm or lower is absorbed by TiO2 coating 10. Light with longer wavelengths pass through SiO2 coating 9 and TiO2 coating 10 are absorbed by spherical crystal 2.

The thickness' of both coatings 9, 10 are determined by considering the following: their function as an passivation film for pn junction 7; the function of coating 10 as a photocatalyst; the degree of transmittance with respect to the received spectrum; or the like. In the case of silicon semiconductor spherical crystal 2, the thickness of SiO2 coating 9 is approximately 0.3-0.7 micrometer, and the thickness of TiO2 coating 10 is approximately 0.3-1.0 micrometer.

Next, referring to Figure 7, in step 7, ohmic contacts (electrodes 14, 15) are formed at the lower end of spherical crystal 2 and at the top of p-type diffusion layer 6. These ohmic contacts are formed in a way that they are opposite each other, with the center of spherical crystal 2 interposed between them. First, a pair of openings 11, 12 with diameters of approximately 0.5 mm are formed on the transparent two layers of coatings 9, 10. This is accomplished by known methods of photolithography or plasma etching or the like. In this case, the pair of openings 11, 12 are formed while masking with a corrosion-resistant photoresist 13.

Next, in step 8, from the pair of openings 11, 12 in Figure 7, Ti (titanium) is vapor deposited onto spherical crystal 2 using known vapor deposition methods. Next, Ni (nickel) is vapor deposited. A pair of ohmic contacts of thickness 0.1-1.0 micrometers are formed. Afterwards, they are sintered at 200-300 degrees C in a vacuum. Corrosion-resistant, photoresist 13 is ashed and removed. In this manner, a positive electrode 14 is formed at the top of p-type diffusion layer 6 of spherical crystal 2, and a negative electrode 15 is formed at the bottom of spherical crystal 2. Electrodes 14, 15 become the entrance and exit for the inflow and outflow of current with respect to the outside circuit. Independent and bead-like semiconductor catalyst 1 as shown in Figure 8 is obtained in this manner. An example of the manufacture of a single semiconductor photocatalyst was described above, but in practice, several semiconductor photocatalysts are manufactured at once.

As described later, an assemblage of several semiconductor catalysts 1 are immersed in a pre-selected electrolyte solution, and it can be used to trigger electrochemical reactions by shining light from outside. Materials which have a catalytic function are the preferred material for electrodes 14, 15. The selection of material depends on what is to be generated with the dissociation reaction. Reaction activity and reaction selectivity are used as a basis for selection. For example, in the electrolysis of water, Ru, Ir, as well as the previously described Ni, or their oxides are preferred for the hydrogen generating reducing electrode. When CO2 gas is photoreduced by water, Pd, Rh or the like is the preferred material for the CH4-gas producing reducing electrode.

Next, the operation of semiconductor photocatalyst 1 is explained.

As an example, the following situation will be described: semiconductor catalyst 1 is immersed in an electrolyte solution; light is shined from the outside; and there is electrolysis of the electrolyte solution. When a light such as sunlight which has a wide spectrum distribution is shined on semiconductor catalyst 1, a photovoltage, in which positive electrode 14 becomes positive and negative electrode 15 becomes negative, is generated. This happens as a result of light which has been transmitted through coatings 9, 10 and which is absorbed pn junction 7 and its rear region.

The maximum open circuit voltage which is generated between electrodes 14, 15 is 0.6V. When there is incident light on the surface of TiO2 coating 10 which is a n-type semiconductor, light with a wavelength below approximately 420 nm is absorbed by coating 10. By its photocatalytic action, a plurality of electrons and holes are generated. The energy band gap curves at the surface of TiO2 coating 10 where it is in contact with the phase boundary of the electrolyte solution or the like. A potential barrier similar to a Schottky barrier is created. As a result, the generated holes move to positive electrode 14. At the interface, holes capture electrons and disappear after losing an amount of energy which is close to the energy band obtained by the photo-excitation. This signifies the generation of oxidation action wherein electrons are captured at the surface of TiO2 coating 10. Simultaneously, at positive electrode 14, there is an oxidation action where electrons at the interface are captured by the photovoltage provided by pn junction 7 of silicon. TiO2 coating 10 is electrically in contact with positive electrode 14. As a result, compared with TiO2 alone, the photovoltage provided by pn junction 7 is applied as a bias. The oxidation potential is heightened, and the capturing of higher energy electrons becomes possible. Negative electrode 15 exhibits its reducing action, where electrons are given up to the exterior at the phase boundary of the electrolyte solution or the like. In this manner, semiconductor photocatalyst 1 exhibits its capacity as a photocatalyst which automatically triggers an electrochemical reaction with only the input of light.

Semiconductor photocatalyst 1 which is described above has the following effects.
(a) a micro photocell 17 is constructed by forming on spherical crystal 2, a photovoltaic part 16 which works together with spherical crystal 2 to generate photovoltage. There is formed TiO2 coating 10 which has a photocatalytic function and which is electrically connected to positive electrode 14. As a result, the activation voltage is lowered at electrodes 14, 15. A semiconductor photocatalyst with high energy conversion efficiency is obtained.
(b) By appropriately combining the energy band gap of pn junction 7 of silicon semiconductor spherical crystal 2 and the energy band gap of the metal oxide semiconductor which has photocatalytic function, such as TiO2, or the like, the potential difference between the electrodes can be made to be a suitable potential difference for the electrochemical reaction. The selectivity for the necessary reaction products can be increased.
(c) The surface of spherical crystal 2 is electrochemically protected with a thin oxide film such as TiO2 which is photochemically stable and which has a large energy band gap. The thin oxide film also exhibits functions as a photocatalyst and as an anti-reflective film. As a result, manufacturing costs are lowered. A semiconductor photocatalyst 1 which has a high energy conversion efficiency and high reliability can be realized.
(d) Semiconductor photocatalyst 1 is formed as a comparatively small sphere. A sphere has excellent mechanical strength and is difficult to destroy. Because it can freely move in a liquid, they can be dispersed in necessary places. Furthermore, positive electrode 14 and negative electrode 15 are opposite each other with the center of spherical crystal 2 interposed between them. As a result, while light is being shined, it is possible to electrically connect a plurality of semiconductor photocatalysts 1 in a series by applying an electric field from the outside.
(e) Because semiconductor photocatalyst 1 receives light from the sphere surface, the influence of the angle of incidence of the light is small. There is a high sensitivity to light with a wide incidence directions such as scattering light.
(f) In step 1 of the manufacturing of spherical crystal 2, it is molten in a levitated state. The surface tension of the melt is used to create the sphere and to have it solidify. As a result, there is no mechanical stress and lattice defects remaining in spherical crystal 2. There are no problems of impurity contamination which get mixed in from the container which stores the molten liquid, and a high quality substance is obtained. When a sphere crystal is made by letting the molten solution solidify while it free falls inside a drop tube, the quality is particularly good, with a good sphericity, uniform distribution of the constitution, and few crystal defects.

Next, the spherical crystal manufacturing device which creates silicon semiconductor spherical crystal 2 of step 1 is described. The method of manufacturing spherical semiconductor crystals is also described.

Referring to Figure 9, a spherical crystal manufacturing device 101 comprises: a vertical drop tube 110 which has a diameter of 5-10 cm and a height of approximately 14m; an electromagnetic levitation heating equipment 112 which is placed on the outside of the upper part of drop tube 110; an infrared heater 113 which is an after heater; a material supply device 111 which supplies solid material 2a one at a time; a silicon oil chamber 115 which is housed in a housing area 114 which is continuous with the lower end of drop tube 110; a vacuum pump 116 which suctions air from inside drop tube 110; a gas supply device 117; a pipe system and valves; high speed cameras 118a-118c; a control unit 120 which controls these apparatus. Furthermore, floors 1-5 of the factory are depicted as floors 103a-103e.

Material supply device 111 comprises: a supplier 121; a parts feeder 122 which stores several granular solid material 2a and which supplies them one at a time. Parts feeder 122 has a function of pre-heating solid material 2a and a function for evacuation of atmosphere. A case 123 of a supplier 121 is connected to vacuum pump 116 by a suction pipe 125 which has an electromagnetic switch valve 124. A receiving apparatus 126 is connected to parts feeder 122 by a pathway 128 which has an electromagnetic shutter 127. There is an electromagnetic shutter 130 at an exit pathway 129 of receiving apparatus 126. Vacuum from inside case 123 is introduced via a plurality of small holes to receiving apparatus 126. During the operation of manufacturing device 101, electromagnetic valve 124 is opened, and there is a vacuum inside supplier 121. When supplying solid material 2a from parts feeder 122, electromagnetic shutter 130 is closed. Electromagnetic shutter 127 is opened, and after solid material 2a is supplied to the inside of receiving apparatus 126, electromagnetic shutter 127 is closed. There are electromagnetic valves 136-138 on suction pipes 133-135 which are connected to vacuum pump 116. In order to allow inert gases or oxidizing gases to flow inside drop tube 110 as needed, there are a gas supply device 117, a gas supply pipe 139, branching pipes 139a, 139b, a gas discharge pipe 141, and electromagnetic valves 140, 142. However, if a vacuum is to be maintained inside drop tube 110, gas supply device 117 is stopped, and electromagnetic valves 140, 142 are closed.

Electromagnetic levitation heating equipment 112 is constructed from an upper coil, a lower coil, and a high frequency current generating device 119, and the like. An upward force of magnetic line is generated by the upper coil. A downward magnetic line of force is generated by the lower coil. An induced current is generated in solid material 2a by the magnetic lines of force which change at a high frequency. When solid material 2a is at a central position between the upper and lower coils, the force of the magnetic line of force acting on the induced current are balanced between the upward force and downward force. Solid material 2a is maintained in a levitated state. Solid material 2a is heated by the heat generating action of the induced current. When solid material 2a becomes molten liquid material 2b, the high frequency current is shut down. Molten liquid material 2b begins a free-fall. With this free-fall, molten liquid material 2b becomes spherical by the action of surface tension under a very small gravitational force of 10^-5.

The purpose of infrared heater 113 is for heating only the surface of molten liquid material 2b by a small amount. Infrared heater 113 is placed as a ring around the outside of drop tube 110. Infrared heater 113 is placed at a certain distance away from electromagnetic levitation heating equipment 112. Infrared heater 113 comprises a cylindrical heater body which is made of an infrared radiation ceramics. By controlling the current which is supplied to this heater body, the heating function can be controlled precisely. Because molten liquid material 2b rotates while free falling, only the surface of molten liquid material 2b is heated evenly by infrared heater 113.

Next, the operations will be described where manufacturing device 101 is used to make spherical crystal 2 from n-type silicon solid material 2a. In the first preparation stage, electromagnetic valves 123, 136, 137, 138 are opened. Vacuum pump 116 is operated, and specified vacuum conditions are created inside drop tube 110. A single solid material 2a is stored in receiving apparatus 126. There is a pre-determined current flowing through infrared heater 113. Next, current is run through electromagnetic levitation heating equipment 112. Electromagnetic shutter 130 is opened, and solid material 2a free-falls. While in a levitated state, solid material 2a is heated by electromagnetic levitation heating equipment 112 for a specified short amount of time. Solid material 2a becomes molten liquid material 2b. Referring to Figure 10(a), the temperature distribution of molten liquid material 2b at this time is such that the temperature is roughly the same in both the interior and on the surface of molten liquid material 2b.

Next, the current to electromagnetic levitation heating equipment 112 is shut off. Molten liquid material 2b begins a free fall in the vacuum of drop tube 110. Because liquid molten material 2b is under microgravity conditions, after the commencement of the free-fall, molten liquid material 2b becomes spherical by the action of surface tension. Molten liquid material 2b initially falls with a low speed. In the short time it takes to fall to the level of the upper end of infrared heater 113, there is radiative cooling, and there is heat release. Because there is heat release from the surface of molten liquid material 2b, the surface of molten liquid material 2b is cooler than the interior (refer to temperature distribution in Figure 10(b)).

Next, during the free fall of the molten liquid material 2b through the interior of infrared heater 113, only the surface is heated. Referring to Figure 10(c), the surface of liquid molten material 2b is warmer than the interior. Next, while it is free falling towards the bottom of infrared heater 113, molten liquid material 2b releases heat through radiative cooling. By the action of surface tension, molten liquid material 2b solidifies to a truly spherical crystal 2.

After passing through infrared heater 113, radiative cooling progresses. Referring to Figure 10(d), the temperature distribution of molten liquid material 2b when the temperature has dropped to near the solidifying point T0 is indicated by the solid line or the dotted line. Because solidification begins with these conditions, solidification begins from the interior and from the surface of molten liquid material 2b. As a result, even if there is volume expansion during solidification, there are no projections formed on the surface of spherical crystal 2. The inner mechanical stress of spherical crystal 2 also becomes very small. Afterwards, spherical crystal 2, which has finished solidification at around the middle level of drop tube 110, drops into silicon oil inside silicon oil chamber 115. They are stored there and are cooled completely. Even though the interior distortions is reduced in spherical crystal 2 described above, if the overall spherical crystal 2 does not become a monocrystal, afterwards, spherical crystal 2 can be made into a monocrystal through anneal processing.

Spherical crystal 2 which is truly spherical and which is without any projections can be manufactured in the above manner. Even if there are projections which have formed, they are extremely small projections which can be eliminated during the annealing process. Furthermore, because the surface of molten liquid material 2b does not solidify before the inside does, any bubbles on the surface of solid material 2a does not mix in spherical crystal 2. Because molten liquid material 2b solidifies to spherical crystal 2 under microgravity conditions, a spherical crystal 2 with an uniform constitutional distribution with no influence from heat convection, buoyancy, sedimentation is achieved.

### Modification mode 1 ... (refer to Figure 11).

Next, semiconductor photocatalyst 1A which is a partial modification of semiconductor photocatalyst 1 will be described. However, the description of elements which have the same numerals as those which have been described previously are abbreviated. Referring to Figure 11, in this semiconductor photocatalyst 1A, instead of TiO2 coating 10, there is a Si3N4 (silicon nitride) coating 20 (thickness approximately 0.3-0.7 micrometer) which is formed by PVD or CVD method. Furthermore, a TiO2 electrode coating 21 (thickness approximately 1.0 micrometer) is formed by PVD or CVD method. Electrode coating 21 covers a large proportion of the surface of the upper half of spherical crystal 2, including the surface of positive electrode 14. Because positive electrode 14 is masked by TiO2 electrode coating 21, a direct exchange of electrons with the outer interface is not possible. Instead, electrode coating 21 functions as a positive electrode which has an oxidative action.

As described previously, because the energy band is bent at the surface of TiO2 electrode coating 21, a plurality of electron and hole pairs are generated when light is received. Holes accumulate at the phase boundary. This becomes a positive electric potential compared with negative electrode 15, and it acts in a way to run current to the outside. When this current flows, an oxidation reaction is generated at the surface of electrode coating 21 which has a photocatalytic function. A reduction action is generated at negative electrode 15. When semiconductor photocatalyst 1A receives sunlight, TiO2 electrode coating 21 absorbs light at wavelengths shorter than approximately 410 nm. Light with longer wavelengths are absorbed by micro photocell 17.

The photovoltage generated at pn junction 7 is a bias with respect to electrode coating 21 and heightens the surface electric potential of electrode coating 21. As a result, the oxidation voltage at electrode coating 21 is heightened, and the electrical energy which is available for electrochemical reactions is heightened. TiO2 has a larger energy band gap than the silicon semiconductor of spherical crystal 2, and it also absorbs short wavelength light to photo-excite electrons and holes. Because electrode coating 21 is formed from TiO2, light such as sunlight, which has a wide spectral distribution, can be efficiently converted to chemical energy. Furthermore, the electric potential between the oxidation and reducing electrodes can be made large.

### Example 1... (refer to Figure 12)

Next, an unclaimed semiconductor photocatalyst 1B which is a partial modification of semiconductor photocatalyst 1 will be described. However, the description of elements which have the same numerals as those which have been described previously are abbreviated. Referring to Figure 12, a SiO2 coating 9A (thickness 0.3-0.7 micrometer) covers the surface of the lower half of spherical crystal, except at the surface of negative electrode 15. An Si3N4 coating 20A (thickness approximately 0.3-1.0 micrometer) covers the surface of coating 9A. These coatings 9A and 20A are formed by PVD or CVD method. A TiO2 electrode coating 22 (thickness approximately 0.3-0.7 micrometer) covers a large portion of the surface of p-type diffusion layer 6. TiO2 electrode coating 22 is formed so that it does not contact pn junction 7. A hetero-junction 23 is formed between p-type diffusion layer 6 and coating 22. The energy band gap of hetero-junction 23 is different from p-type diffusion layer 6.

When manufacturing semiconductor photocatalyst 1B, coatings 9A, 20A are formed over the entire surface of spherical crystal 2 including p-type diffusion layer 6. Afterwards, the areas which correspond to electrode coating 22 are removed by etching, and electrode coating 22 is formed. An opening can be formed in coatings 9A, 20A in order to form negative electrode 15. The manufacturing method is not limited to this, but semiconductor photocatalyst 1B can be manufactured by various known techniques.

When light such as sunlight or the like is shined on semiconductor photocatalyst 1B, holes accumulate at the surface of electrode coating 22. It functions as an oxidizing electrode which takes electrons at the phase boundary. The photovoltage of micro photocell 17 increases the surface electric potential of electrode coating 22. It functions in the same manner as semiconductor photocatalyst 1A of modification mode I. Because there is no metallic positive electrode which can obstruct incident light, the entire surface of electrode coating 22 functions as an efficient photocatalyst. Because the barrier height of hetero-junction 23 is reduced by light generated carriers, the photochemical conversion efficiency is heightened.

### Example 2... (refer to Figure 13)

Next, an unclaimed semiconductor photocatalyst 1C which is a partial modification of semiconductor photocatalyst 1 will be described. However, the description of elements which have the same numerals as those which have been described previously are abbreviated. Referring to Figure 13, spherical crystal 2A is a spherical crystal of an n-type silicon semiconductor without the p-type diffusion layer 6. On the surface of spherical crystal 2A, a SiO2 coating 24 (thickness 1.5-3.0 nm) covers the entire surface, except at negative electrode 15. A metal coating 25 (thickness approximately 10-15nm) covers the surface of coating 24 at the top half of spherical crystal 2A. Metal coating 25 is, for example, a Ti or Ni coating. With this MIS configuration there is a bending of the energy band similar to a pn junction at the interface of spherical crystal 2A and SiO2 coating 24 underneath metal coating 25. There is formed a photovoltaic part 16Cwhich contains an energy band bending layer 6C near the surface, and there is formed a microphotocell 17C.

### Example 3... (refer to Figure 14)

Next, an unclaimed semiconductor photocatalyst 1D which is a partial modification of semiconductor photocatalyst 1 will be described. However, the description of elements which have the same numerals as those which have been described previously are abbreviated. Referring to Figure 14, spherical crystal 2A is a spherical crystal of an n-type silicon semiconductor without the p-type diffusion layer 6. On the upper half of spherical crystal 2A, a metal coating 27 (thickness approximately 10-15 nm) is formed. Metal coating 27 is, for example, a Ti or Ni coating. An SiO2 insulating coating 9D (protective film) (thickness approximately 0.3-0.7 micrometer) covers the surface of the lower half of spherical crystal 2A, except at electrode 15. With this Schottky barrier construction, there is a bending of the energy band similar to at a pn junction at the interface of spherical crystal 2A and metal coating 27. There is formed a photovoltaic part 16D which contains an energy band bending layer 6D near the surface, and there is formed a microphotocell 17D.

The semiconductor photocatalyst of the present invention is not limited to what has been described above in relation to Figures I-II. The following changes can be added.
(1) TiO2 coating 10 and electrode coatings 21, 22 which are used as photocatalysts and which have a large energy band gap are not absolutely necessary. TiO2 coating 10 can be omitted. For the objectives of passivation and anti-reflection, an Si3N4 coating can be formed on the surface of SiO2 coating 9 so that the entire microphotocell 17 is protected. In this case, the oxidation-reduction voltage is limited by the open circuit voltage of pn junction 7 generated between positive electrode 14 and negative electrode 15. But the catalytic action of electrodes 14, 15 still remain.
(2) Spherical crystal 2 can be constructed of p-type silicon semiconductor. Instead of a p-type diffusion layer 6, an n-type diffusion layer can be formed. Furthermore, the n-type or p-type semiconductor which is to be used for spherical crystal 2, 2A is not limited to Si semiconductor, but semiconductors of SiGe, SiC, or the like, Group III-V compound semiconductors of GaAs or InP or the like, chalcopyrite semiconductors such as CuInSe2 or the like can also be used.
(3) Materials which can be used as an anti-reflective film and which have passivating function, in addition to SiO2 and Si3N4, include the following: Al2O3, Ta2O5, TiO2, MgF2, SnO2, or Nb2O5. However, the material should be selected in relation to the material of spherical crystal 2, 2A. (4) Instead of coating 10 or electrode coatings 21, 22 of TiO2 which has a photocatalytic function, a coating of metal oxide semiconductors which have photocatalytic function can be used. These include: SrTiO3, Fe203, PbxTi1-xO2 or the like.
Furthermore, the size of semiconductor photocatalysts 1-1D is not limited to that of the embodiments. They can be made bigger or smaller.

### Electrolysis device with semiconductor photocatalyst (refer to Figures 15-17)

Next, an electrolysis device with a semiconductor photocatalyst (will be referred as electrolysis device) is described. This electrolysis device uses an aggregate in which several semiconductor photocatalysts 1 are aggregated.

Referring to Figure 15, electrolysis device 30 stores a pre-selected electrolyte solution 31. In addition, electrolysis device 30 comprises: an electrolyte solution chamber 32 (made of glass, for example) which stores a plurality of semiconductor photocatalysts 1 immersed in electrolyte solution 31; a plurality of semiconductor photocatalysts 1 which are stored at the bottom of electrolyte solution chamber 32; a right and left pair of a positive electrode 34 and a negative electrode 35 which are placed on either end inside electrolyte solution chamber 32 and which applies a common electric field to the plurality of semiconductor photocatalysts; a power supply device 36 which applies a specified serial voltage between positive electrode 34 and negative electrode 35; a glass cover 33 for collecting gas which is generated; a pipe 37 which replenishes electrolyte solution 31; a gas exit pipe 38 through which generated gas is removed.

When conducting electrolysis using electrolysis device 30, an aqueous solution of methanol, for example, of a specified concentration fills electrolyte solution chamber 31 to a specified depth. Sunlight 41 is shined from above, and photovoltage is generated in a plurality of semiconductor photocatalysts 1. A serial voltage is applied from positive electrode 34 to negative electrode 35 via electrolyte solution 31.

Almost all of the semiconductor photocatalysts is given a direction by the electric force as a result of the bipolar phenomenon. Negative electrode 15 of each of the semiconductor photocatalysts 1 faces towards positive electrode 34, and positive electrode 14 face toward negative electrode 35. 2-4 of the semiconductor photocatalysts become electrically connected in series. Even if the application of serial voltage is terminated afterwards, the serial connection continues. Under these conditions, electrolysis device 30 is operated. Electrolysis of electrolyte solution 31 occurs. Electrolyte solution 31 (methanol solution) is oxidized at positive electrode 14 and at the surface of TiO2 coating 10 which is in contact with positive electrode 14. The solution is reduced at the surface of negative electrode 15. As a result, CO2 gas 40 is generated at positive electrode 14 and at the surface of coating 10. H2 gas 39 is generated at the surface of negative electrode 15.

The mixture gas of generated CO2 gas 40 and H2 gas 39 is guided by cover 33 and is sent to a gas tank (not shown) from gas exit pipe 38. The mixture gas is separated by a gas separating device which is connected to the gas tank. In electrolysis device 30, the individual semiconductor photocatalysts 1 are not anchored to electrolyte solution chamber 32. When light stops shining, they can be moved independently. They can be dispersed in places where they are needed, and they can be removed and cleaned from time to time.

Here, a device which has partial modifications to electrolysis device 30 is described.

Referring to Figure 16, in electrolysis device 30A, there is a plurality of shallow grooves 32a formed at the bottom of electrolyte solution chamber 32A. Grooves 32a house the bottoms of semiconductor photocatalysts 1. Semiconductor photocatalysts 1 are capable of movement. Two rows of semiconductor photocatalysts 1 are housed in each groove 32a. Grooves 32a continue out in a direction perpendicular to the paper. When a plurality of semiconductor photocatalysts 1 are placed into electrolyte solution chamber 32A without any electrolyte solution 31, approximately 2 rows of semiconductor photocatalysts 1 fit into each groove 32a. An electrical field is applied as before, and a plurality of semiconductor photocatalysts 1 become connected in series, two at a time, in each groove 32a. In this manner, the potential difference between the reducing and oxidizing electrodes 14, 15 can be made to be twice as large as the photovoltage of an individual semiconductor photocatalyst 1. It is easy to make modifications to have each groove 32a house two or more rows of semiconductor photocatalysts 1 in a configuration where they can be serially connected. This can be done by changing the shape of groove 32a on the bottom of electrolyte solution chamber 32A, or by placing at the bottom of electrolyte solution chamber 32A a removable member in which grooves 32a are formed. The size of the photovoltage can be specified freely. As a result, electrolysis of various types of electrolyte solutions can be conducted.

Next, a device in which partial modifications to electrolysis solution 30 have been made is described.

Referring to Figure 17, electrolysis device 30B is a device for the electrolysis of water 31B. Because the electrolysis voltage of water is higher than that of methanol solution, there is a need to serially connect semiconductor photocatalysts 1 three at a time. At the bottom of electrolyte solution chamber 32B, a plurality of shallow grooves 32b are formed. Groove 32b can house three rows of the bottoms of semiconductor photocatalyst 1. Groove 32b continue out in a direction perpendicular to the paper. As before, by applying an electrical field from electrodes 34, 35, semiconductor photocatalysts 1 can be connected in series 3 at a time.

From positive electrode 14 and from the surface of TiO2 coating 10 of the serially connected semiconductor photocatalysts 1, O2 gas 42 is generated. From the surface of negative electrode 15, H2 gas 39 is generated. O2 gas 42 and H2 gas 39 are collected separately. On the lower surface of cover 33b, there are a plurality of semipermeable membranes 43 which partition H2 gas 39 and O2 gas 42. On cover 33B, there is a plurality of gas pathways 44 for removing H2 gas 39, and there is a plurality of gas pathways 45 for removing O2 gas 42. Gas pathway 44 is connected to a hydrogen gas tank, and gas pathway 45 is connected to an oxygen gas tank.

According to the electrolysis device 30-30B, spherical semiconductor photocatalysts 1 which are each independent are used. As a result, there are several advantages, including the following: there is no reduction in light absorption efficiency with changes in the angle of incidence of light; placing and removing of semiconductor photocatalysts 1 are convenient; it has excellent generalizability because a specified number of semiconductor photocatalysts 1 can be connected in series to generate the desired photovoltage depending on the required electrolysis voltage for the electrolysis solution.

It does not need to be stated that the various advantages of the semiconductor photocatalysts which were previously described still apply. For electrolytic devices 30-30B, semiconductor photocatalysts 1A-1D can also be used instead of semiconductor photocatalyst 1.

### EMBODIMENT 2 (Referring to Figures 18-28)

Referring to Figure 18, the semiconductor device of this embodiment is composed of a single or a plurality of independent, bead-like spherical solar cell 200 (spherical semiconductor element).

Referring to Figure 18, there is shown a cross-section of spherical solar cell 200. As an example, a spherical crystal 201 of p-type silicon semiconductor material is manufactured using semiconductor spherical crystal manufacturing device 101. Its diameter is 1.5 mm, and the resistivity is 1 ohm-cm. After forming a diffusion mask similar to one described in Embodiment 1, spherical crystal 201 is heated to 850-950 degrees C in an atmosphere which contains P (phosphorus). By diffusing phosphorus into the surface of spherical crystal 201, and an n-type diffusion layer 202 is formed. A pn junction 203 is formed.

The dopant concentration at n-type diffusion layer 202 is 2-4 x 10^20 cm^-3. Pn junction 203 is formed at a depth of 0.5 micrometer from the surface of spherical crystal 201.

Next, after removing the SiO2 coating from the surface of spherical crystal 201, an insulating coating 204 for the purpose of surface protection and anti-reflection is formed by the CVD method. As in semiconductor photocatalyst 1, insulating coating 204 comprises, for example, a coating of SiO2 and a coating of TiO on its surface.

Next, holes 205, 206 of diameter 0.2 mm are opened at the lower end of spherical crystal 201 and at the top end of insulating coating 204. Holes 205, 206 are opened by sandblasting method or the like. The silicon surface is exposed. Next, while masking everything except for the pair of holes 205, 206, a 50nm thick Pd (palladium) coating is formed by electroless plating. Afterwards, a 2 micrometer thick Ni (nickel) coating is formed on the Pd coating. Afterwards, this is heat processed at 400 degrees C. In this manner, a positive electrode 207 which is electrically connected to the p-type silicon and a negative electrode 208 which is electrically connected to n-type diffusion layer 202 is formed. Next, the surfaces of both electrodes 207, 208 are covered with soldering films 209, 210 with an approximate thickness of 20 micrometer. Because positive electrode 207 and negative electrode 208 are formed so that they oppose each other, with the center of spherical crystal 201 in between them, it is possible to line up a plurality of solar cells 200 in a row and electrically connect them in a serial manner, as in semiconductor photocatalyst 1.

Besides using the gas diffusion method, the n-type diffusion layer 202 can be formed by a solid phase diffusion method, an ion implantation method. Insulating coating 204 can be formed by the PVD method. Furthermore, both electrodes 207, 208 can be formed by vapor deposition method. Furthermore, a p-type diffusion layer can be formed on a spherical crystal of a n-type silicon semiconductor. The material and thickness of insulating coatings 204, electrodes 207, 208 can be adjusted appropriately as needed. The semiconductor which forms spherical crystal 201 is not limited to silicon semiconductors. Various semiconductors which have been listed in previous embodiments may be used.

Solar cell 200, as described above, generate photovoltage by receiving sunlight. Therefore, they can be used as semiconductor photocatalysts or solar batteries. When a plurality of solar cells 200 are placed in an electrolyte solution or in an organic gas, an electrochemical reaction is induced. The electrolyte solution or the organic gas dissociates.

In solar cell 200 which uses the silicon semiconductor, the open circuit voltage between positive electrode 207 and negative electrode 208 is approximately 0.6V at maximum. The magnitude of the open circuit voltage is limited by the energy band gap of the semiconductor used in spherical crystal 201. For example, when using a GaAs type semiconductor crystal, it becomes approximately 1.0 V. As described in Embodiment 1, the photovoltage can be increased by lining up a plurality of solar cell 200 in a row and electrically connecting them in series.

Solar cell 200 can be incorporated into an electrical circuit and be used as a light sensor. However, when using it as a photodiode, the design needs to be altered depending on the objective. When making it into a spherical semiconductor element which functions as a light-emitting diode, spherical crystal 201 is constructed into a configuration which is similar to known light-emitting diodes, using semiconductors of GaP, GaAs, SiC, or the like. The spherical crystal has a single or a plurality of pn junctions. When current is run in the forward direction between the positive and negative electrode, there is light emitted at the pn junction. This light radiates to the outside (refer to Embodiment 3).

### Modification mode 1 ... (refer to Figure 19)

A semiconductor device which is a partial modification of the previous semiconductor device is described. However, the description of elements which have the same numerals as those which have been described previously are abbreviated.

Referring to Figure 19, the semiconductor device of this modification mode is constructed from a single, independent, and bead-like rectifier diode 215 (spherical semiconductor element) which is shown.

Referring to Figure 19, there is shown a cross-sectional diagram of rectifier diode 215. A p-type diffusion layer where a p-type dopant is diffused and a pn-junction 218 is formed on a spherical crystal 216 of n-type silicon semiconductor. Insulating coating 204, negative electrode 207a, positive electrode 208a, and soldering films 209, 210 are formed as described before. Electrodes 207a, 208a can be made larger than the electrodes of solar cell 200 in Figure 18. By making appropriate design changes, the devices can be made into constant voltage diodes (zenerdiodes) or variable capacitance diodes.

### Modification mode 2 ... (refer to Figure 20)

A semiconductor device relating to a modification mode will be described. However, the description of elements which have the same numerals as those which have been described previously are abbreviated. In this semiconductor device, a single, independent, and bead-like photodiode cell 221 (spherical semiconductor element) is housed inside a transparent, glass case 222. The semiconductor device is a photodiode 220 with a pair of lead pins 224, 226 as the external electrodes.

Photodiode cell 221 has approximately the same configuration as solar cell 200. A n-type diffusion layer 202 where a n-type dopant is diffused and a pn-junction 203 is formed on a spherical crystal 201 of p-type silicon semiconductor. Spherical crystal 201 has a diameter of 1.5 mm and a resistivity of around 20 ohm-cm. Insulating coating 204, electrodes 207, 208, and soldering films 209, 210 are formed as described before. However, pn junction 203 is formed at a depth of 2 micrometers from the surface of spherical crystal 201. The glass tube which is case 222 has an inner diameter of approximately 1.6 mm, an outer diameter of approximately 2.6 mm, length of approximately 5.0mm. It is constructed from a glass which has lK20.PbO.SiO2 type excellent light transparency and which can be sealed at relatively low temperature. First, a positive electrode lead pin 224 (external electrode) hermetically seals one end of storage cavity 223 of case 222 by fusing with a sealing glass 225. Next, under an inert gas, photodiode cell 221 is stored in storage cavity 223 from the other end of storage cavity 223. Soldering film 209 of positive electrode 207 is brought into contact with the tip of positive electrode lead pin 224. Next, under the gas described above, negative electrode lead pin 226 (external electrode) is placed on the other end of storage cavity 223. While the tip of lead pin 226 is pressed against solder film 210 of negative electrode 208, negative electrode lead pin 226 hermetically seals storage cavity 233 by fusing with a sealing glass 227. Afterwards, by heating the entirety, positive electrode lead pin 224 and soldering film 209, negative electrode lead pin 226 and soldering film 210 are connected. Afterwards, lead pins 224, 226 are connected to an external circuit. The air space inside storage cavity 223 is filled with an inert gas. When light is shined on photodiode cell 221, there is generated a photovoltage on lead pins 224, 226, which is a function of the intensity of the light. As a result, it can be used as a light sensor. Because light can be received from all surfaces except at electrodes 207, 208, there is no limitations on the direction of incoming light.

### Modification mode 3 ... (refer to Figures 21, 22)

A modification mode of a semiconductor device will be described. However, the description of elements which have the same numerals as those which have been described previously are abbreviated. This semiconductor device is a solar battery device 230 which has a solar cell array 231 (semiconductor element array) in which 5 independent, bead-like, solar cells 200 (spherical semiconductor element) are lined in a row and are electrically connected in series. Solar cell array 231 is housed inside a transparent, glass case 232. Solar battery device 230 has a pair of lead pins 234, 236 as external electrodes.

These solar cells 200 are the same as those shown in Figure 18, except that they have a diameter of 0.5 mm. The glass tube for case 232 has an inner diameter of approximately 0.65 mm, an outer diameter of approximately 1.35 mm, a length of approximately 7.5 mm. It is constructed from the same glass as in modification mode 2. First, positive electrode lead pin 234 (external electrode) hermetically seals one end of storage cavity 233 of case 232 by fusing with a sealing glass 235. Next, under an inert gas, solar cell array 231 is placed inside storage cavity 235 from the other end. Soldering film 209 of positive electrode 207 of solar cell 200 at one end of solar cell array 231 is brought into contact with the tip of positive electrode lead pin 234. Next, under the same gas, negative lead pin 236 (external electrode) is placed at the other end of storage cavity 233. While the tip of lead pin 236 is pressed against solder film 210 of negative electrode 208 of the solar cell 200 at the other end, negative electrode lead pin 236 hermetically seals storage cavity 235 by fusing with a sealing glass 237. Afterwards, by heating the entirety, positive electrode lead pin 234 and soldering film 209, negative electrode lead pin 236 and soldering film 210 are electrically connected. Afterwards, lead pins 234, 236 are connected to an external circuit. The air space inside storage cavity 233 is filled with an inert gas. When light is shined on solar cell array 231, there is generated a photovoltage on lead pins 234, 236, which is a function of the intensity of the light. As with the previous photodiode, there are no limitations on the direction of incoming light. When electrically connecting solar cell array 231 in series, the five solar cells 200 are retained in a horizontal, single-column groove of a specified container. While shining light, the container is vibrated while applying an external electric field.

In this solar battery device 230 and in the solar battery 240 which will be described later, soldering films 209, 210 can be omitted. Instead, electrodes 207, 208 can incorporate a magnetic substance such as Ni or the like, and it can be magnetized. They can be connected by magnetism. Furthermore, for each solar cell 200, a thick film conductive synthetic resin can be used instead of soldering film 209, 210. Furthermore, an elastic metal member such as a disk spring or the like can be interposed between electrodes 207, 208 and the corresponding lead pins 234, 236. Solar battery device 230A is a partial modification of solar battery device 230. Referring to Figure 23, instead of glass case 232, a transparent synthetic resin (for example silicone resin or the like) case member 232A is used. Solar cell array 231 is imbedded in the interior of the case member.

### Modification mode 4... (refer to Figures 24, 25)

A semiconductor device which is a modification mode will be explained. However, the description of elements which have the same numerals as those which have been described previously are abbreviated. This semiconductor device is a solar battery module in which modification mode 3 has been enlarged in 2 dimensions to become sheet-like or panel-like. In a transparent case 242 which is made from the same glass as described above, 4 storage cavities are formed in parallel. Both main surfaces 242a, 242b form a wave-shaped surface and are the light-receiving surfaces. In each storage cavity 243, there is a solar cell array 241 which is the same as solar cell array 241 of modification mode 3 and a rectifier diode 215 which is the same rectifier diode 215 as in Figure 19. Rectifier diode 215 is electrically connected in series with soldering film 210 of negative electrode 208 of solar cell 200 which is on the negative electrode side of solar cell array 241. There is positive electrode lead pin 244 on one end of each storage cavity 243, and each storage cavity 243 is sealed by sealing glass 245. The tip of each positive electrode 244lead pin is electrically connected to soldering film 209 of positive electrode 207 of the corresponding solar cell. On the other end of each storage cavity 243, a negative electrode lead pin 246 is inserted and is sealed by sealing glass 247. The tip of each negative electrode lead pin 246 is electrically connected to soldering film 210 of negative electrode 208 of the corresponding rectifier diode 215. Furthermore, the air spaces in each storage cavity 243 is filled with an inert gas. The four positive electrode lead pins 244 and the four negative electrode lead pins 246 are each connected in parallel, and are connected to an outside circuit.

When solar cell array 241 is connected in parallel, and the output power is increased, a difference in photovoltage between solar cell arrays 241 is created. Reverse current could flow from one solar cell array 241 with a high voltage to another solar cell array 241 of a lower voltage. The purpose of having a rectifier diode 215 is to prevent overheating of solar cell array 241.

When sunlight is incident on main surfaces 242a or 242b of solar battery module 240, a photovoltage is generated in which positive electrode 207 becomes positive and negative electrode 208 becomes negative. Between positive electrode lead pin 244 and negative electrode lead pin 246 of each row, the voltage is the sum of the photovoltages from the five solar cells 200 minus the forward voltage drop of rectifier diode 215. As a result, there is output to the outside circuit which is connected to lead pins 244, 246.

The number of serial connections in solar cell array 241 and the number of rows of solar cell array 241 can be specified freely depending on the output voltage and output current which is needed. Furthermore, main surfaces 242a, 242b of case 242 can be formed as planes. Case 242 can be constructed from a synthetic resin (for example, silicone resin or the like) which has excellent light transparency. Solar battery module 240A is a partial modification of solar battery module 240. Referring to Figures 26, 27, instead of case 242, a case member 242A made of a transparent synthetic resin (silicone resin or the like, for example) can be used. Each row of solar cell array 241 and rectifier diode 215 are embedded in the interior of case member 242A. Both main surfaces 248a, 248b of case member 242A are formed as parallel planes. Furthermore, referring to Figure 27, case member 242A can have a construction in which two sheet materials are joined at the surface along dotted line 249.

In solar battery module 240 described above, both ends of each storage cavity 243 are hermetically sealed by lead pins 244, 246 and sealing glass 245, 247. The interior is filled with inert gas. Solar cell 200 is electrochemically protected. Solar cell 200 does not degrade easily and has excellent durability. This is also true for solar battery module 242A. Main surfaces 242a, 242b of case 242 have a geometrically symmetrical construction. Photovoltage is generated whether light is received from the front or the back. In order to receive light from wide angles, main surfaces 242a, 242b have curved surfaces which are like partial cylinders. As a result, it has an excellent light capturing capability with respect to light, such as sunlight, which has a fluctuating angle of incidence.

In solar battery device 230 and solar battery module 240, of the light which passes through case 232, 242, incident light which enters at an angle of incidence greater than the critical angle of incidence repeat several-fold reflections off the surfaces of nearby solar cells 200. In the end, the light is more easily absorbed in the interior, and the photoelectric conversion efficiency is improved. In solar battery module 240, of the incident light which is not photoelectrically converted, because the light passes through case 242 and is transmitted to the opposite side, solar battery module 240 can be used as a solar battery which also serves as window glass. The solar battery module of the prior art had solar cells interposed between a support plate and a transparent cover glass. This was then filled with a transparent synthetic resin. The module also had an interconnector and a moisture proof sheet. However, solar battery module 240 has excellent air-tightness and durability. Transparent synthetic resin for sealing, interconnector, moisture proof sheet, and the like are all unnecessary. As a result, it is a simple configuration.

Solar battery devices 230, 230A, and solar battery modules 240, 240A have excellent air-tightness and water tightness. Because solar cell 200 is stored inside case 232, 242, or case member 232A, 242A, this device is suited for using sunlight as an energy source while being immersed in water, various electrolyte solutions, or sewage to be processed. For example, referring to Figure 28, there is shown a water electrolysis device 250 which has a built-in solar battery module 240. Solar battery module 240 and water 254 are stored in an electrolytic bath 251. There is a lid member 252 which covers the upper end of electrolytic bath 251. There is a barrier membrane 253 which is a semi-permeable membrane. When sunlight is shined from above, electrolysis is triggered by the photovoltage of solar battery module 240. Oxygen gas 255 is generated from the surface of positive electrode lead pin 244. Hydrogen gas 256 is generated from the surface of negative electrode lead pin 246.

Next, there will be a general description of the advantages of various semiconductor devices of Embodiment 2. Because spherical semiconductor elements of solar cell 200, rectifier diode 215 and the like are spherical particles, they have excellent mechanical strength and are difficult to damage. Because each spherical semiconductor element has a pair of electrodes 207, 208 which are opposite each other, a plurality of solar cells can be electrically connected in series easily. Because semiconductor devices can be constructed by combining various elements depending on its purpose, it is very generalizable and practical. Insulating coating 204 is formed, and because the distance between positive electrode 207 and negative electrode 208 is large, the reverse reaction is prevented. There is no optical directionality. Because there is an optical symmetry which is close to the symmetry of a sphere surface, it has excellent light capturing ability, in particular the capturing of sunlight. The same is true for light-emitting elements.

The diameter of the spherical semiconductor element is small. The area of the pn junction or the like becomes larger relative to its volume. As a result, the utilization efficiency of the semiconductor material is high. Furthermore, when manufacturing solar battery device 230 or solar battery module 240, wiring by die bonding or wire bonding is not necessary. As a result, assembly is simple, and the cost is reduced. In addition, breaking of wire connections do not occur. As described above, light absorption is increased by the multi-fold reflections, and photochemical conversion efficiency is improved. The same is true for light emitting diode arrays. Light emission is heightened by the multiple reflections. Because the diameter of spherical semiconductor elements are small, case 232, 242 can be made with a thin construction, and the overall thickness and volume become smaller. This is advantageous in terms of manufacturing costs.

### EMBODIMENT 3 (referring to Figures 29-34).

Referring to Figure 29, the semiconductor device of this embodiment is a color display panel 300 which aligns light-emitting diodes into a plurality of rows and a plurality of columns. Light emitting diodes 310, 320, 330 are light emitting diodes which emit red light (R), green light (G), and blue light (B), respectively. In each row, light emitting diodes 310, 320, 330 are placed cyclically in the order of RGB. In each column, light emitting diodes 310, 330, 320 are placed cyclically in the order of RBG.

The control and driving means which drives display panel 300 and displays the color image is the same control and driving means of the known color display panel which uses three color light-emitting diodes of RGB. It will be explained briefly.

Positive electrode 315 of light-emitting diode 310 in each column is connected to a common signal line 310a (data line). A plurality of signal lines 310a are connected to a driver 341. Driving signals from driver 341 are supplied in a time series to a plurality of signal wires 310a. Negative electrode 317 of light-emitting diodes 310 of each row is connected to a common line 310b. A plurality of common line 310b is connected to driver 344. All of the voltage of common line 310b is controlled by driver 344. For example, a driving signal is outputted from a signal line 310a in the first column. When the common line 310b of the first row and the fourth row is grounded, light emitting diode 310 of first row and light emitting diode 310 of the fourth row of the first column emit light. The same is true for light emitting diodes 320, 330. There are a plurality of signals 320a, driver 342, a plurality of common lines 320b and driver 345 for the plurality of light emitting diodes 320. There are a plurality of signal lines 330a, driver 343, a plurality of common lines 330b and driver 346 for the plurality of light emitting diodes 330. Referring to Figure 29, 30, in this way, light-emitting diodes 310, 320, 330 are connected with signal lines 310a, 320a, 330a, and to common lines 310b, 320b, 330b, respectively. A control unit 340 synchronizes and controls each of the drivers 341, 344, 342, 245, 343, 346 of each group. Furthermore, the common lines 310b, 320b, 330b do not have to be independent, but can be constructed as one common common line.

Next, the configuration and manufacturing method for light-emitting diodes 310, 320, 330 will be described.

First, referring to Figure 31, a spherical crystal 311 with a diameter of 1.5 mm is manufactured using spherical crystal manufacturing device 101 described previously. Spherical crystal 311 is of an n-type GaAs semiconductor to which Si has been added as the dopant. As will be described later, the amount of Si to be added is specified so that the infrared light which is emitted has a peak wavelength of 940-980 nm.

Next, a Si3N4 coating 312 (thickness approximately 0.1 micrometer) is formed over the entire surface of spherical crystal 311 by the CVD method. Referring to Figure 32, coating 312 which is on the top half of spherical crystal 311 is removed by photoetching. Next, on the surface of the upper half of spherical crystal 311, a p-type dopant of Zn is diffused by heating, and a p-type diffusion layer 313 is formed. A pn junction 314 is formed. The concentration of dopant in p-type diffusion layer 313 is 2-8x 10^19 cm^-3. Afterwards, Si3N4 coating 312 on the bottom half of spherical crystal 311 is removed.

Next, referring to Figure 33, the same things as described in embodiment 1 are done. At the top of p-type diffusion layer 313 of spherical crystal 311, an anode 315 (thickness approximately 1 micrometer) of Au with 1% of Zn is formed. At the lower end of spherical crystal 311, a cathode 316 (thickness 1 micrometer) of Au with small amounts of Ge and Ni is formed. Referring to Figure 33, for spherical crystal 311, when a voltage of approximately 1.4 V is applied from anode 315 to cathode 316, an infrared light with a peak wavelength of 940-980 nm is emitted from pn junction 314.

Next, referring to Figure 34, a fluorescent coating 317 (thickness approximately 1-10 micrometer) which converts infrared light to visible light is formed over the entire surface of spherical crystal 317, except for at electrodes 315, 316. In order to form fluorescent coating 317, a fine powder of fluorescent material which is described later is mixed in with silicone resin or epoxy resin. This mixture is applied and formed into fluorescent coating 317 by heat curing. For light emitting diode 310 which emits red light, Y0.74Yb0.25Er0.01OCl is used as the fluorescent material. For light emitting diode 320 which emits green light, Y0. 84Yb0. 15Er0.01F3 is used as the fluorescent material. For light emitting diode 330 which emits blue light, Y0.65Yb0.35Tm0.001F3 is used. Other than fluorescent coating 317, light-emitting diodes 310, 320, 330 have the same construction. This is advantageous in the case of mass production. When a voltage of approximately 1.4 V is applied from anode 315 to cathode 316, an infrared light of wavelength 940-980 nm is emitted from pn junction 314 of GaAs. The fluorescent material in fluorescent coating 317 on the surface of spherical crystal 311 absorbs this infrared light. The fluorescent material is excited. Depending on the type of fluorescent material, the infrared light is converted to a wavelength in the visible spectrum and sent out from spherical crystal 311. In this way, red light is emitted from light emitting diode 310, green light is emitted from light emitting diode 320, blue light is emitted from light emitting diode 330. The diameter of light emitting diodes 310, 320, 330 is not limited to the diameter described above (1.5 mm). The diameter can be chosen freely. However, if it is too small, handling becomes tedious. If it is too large, the manufacturing of spherical crystals becomes difficult. The size can be set as desired in the range of 200 micrometer-3.0 mm.

Next, for the construction of display panel 300, the construction other than of light-emitting diodes 310, 320, 330 will be described. Referring to Figure 35, display panel 300 has a base plate 347, a middle plate 348 and a surface plate 349. Base plate 347 comprises: a transparent glass plate 350 with a thickness of approximately 1.0 mm; signal wires 310a, 320a, 330a which are on the surface of glass plate 350 and which are of an Au coating; a Ni reflective coating 351 on the under surface of glass plate 350. Signal lines 310a, 320a, 330a are formed by methods such as Au coating vapor deposition, masking, and etching, or the like. Reflective coating 351 is formed by vapor deposition. Base plate 347 is manufactured and prepared in advance.

Middle plate 348 comprises: a synthetic resin plate 352 of silicone resin or the like and with a thickness of approximately 1.5 mm as an example; cylindrical cavities 353 which are formed on synthetic resin plate 352 with multiple columns and multiple rows; a Ni reflective coating 354 which is formed on the inner perimeter of each cylindrical cavity. First, a plurality of columns and rows of cylindrical cavity 353 are formed on synthetic resin plate 352 by stamping, drilling with laser lights, or by etching. In the inner surface of all of cylindrical cavities 353, a reflective coating 354 is formed by vapor deposition. Middle plate 348 is manufactured and prepared in advance. Surface plate 349 comprises: a transparent glass plate 355 of approximate thickness 1.0mm, common lines 310b, 320b, 330b which are on the under surface of glass plate 355 and which are made of Au coating. Common lines 310b, 320b, 330b can be formed using methods such as vapor deposition of Au coating, masking, etching or the like. Surface plate 349 is manufactured and prepared in advance.

When assembling display panel 300, middle plate 348 is positioned on top of base plate 347 and is glued with a heat resistant adhesive. Next, in each of the multi-row, multi-column cylindrical cavity 353, the corresponding light emitting diode (one of light emitting diode 310, 320, 330) is incorporated. Next, surface plate 349 is positioned on top of middle plate 348 and is glued with a heat resistant adhesive. Finally, everything is heated, and each anode 315 is connected to the corresponding signal line 310a, 320a, 330a. Each cathode 316 is connected with the corresponding common line 310b, 320b, 330b. Display panel 300 which has been described is used in various uses including televisions, personal computers, word processor displays, small-scale liquid crystal display with a variety of uses, display replacing light emitting diode display, large size television, displays, monitors, or the like. Depending on the purpose of the display panel, the diameters of light emitting diodes 310, 320, 330, light emitting characteristic the number of columns and the number of rows can be chosen as appropriate. A full color display was described as an example of a display, but it can be constructed for a monochromatic display where one type of light emitting diode is incorporated. Or a display with 2 types of light-emitting diodes can be constructed.

Display panel 300 is a panel-like display with the overall thickness being approximately 2-3 times the diameter of light-emitting diodes 310, 320, 330. It is compact and light weight. The light emitting diodes 310, 320, 330 which are to be built into display panel 300 can be tested beforehand, and defective products can be removed. Furthermore, with regard to signal lines 310a, 320a, 330a and common lines 310b, 320b, 330b of surface plate 349, these can also be tested beforehand, and defective products can be removed. As a result, display panel 300 can be assembled with excellent reliability. Because the three types of light-emitting diodes 310, 320, 330 can be driven by a common driving voltage (approximately 1.4 V), each of the three common lines 310b, 320b, 330b can be constructed as one common line. The configuration of the driving and controlling circuit is simplified. Because bead-like spherical light-emitting diodes 310, 320, 300 can be mass produced relatively cheaply, display panel 300 can be manufactured relatively cheaply. Furthermore, depending on the required resolution of display panel 300, the sizes of light emitting diodes 310, 320, 330 can be adjusted appropriately. There is a high degree of freedom in design, and a display panel which is suited for its purpose can be produced. Referring to Figure 30, this is only one example of a display panel 300. Various design changes can be made.

## Claims

1. A semiconductor device, comprising:
an independent spherical semiconductor (1) element, comprising:
a spherical crystal (2) of p-type semiconductor or n-type semiconductor;
a photovoltaic part (16) which is incorporated onto the surface or onto an area near the surface of said spherical crystal (2);
said photovoltaic part (16) generating photovoltage in association with said spherical crystal (2);
a pair of electrodes (14,15) for the inflow/outflow of current with respect to an outside circuit, one electrode of the pair being on each side of the photovoltaic part (16) and each electrode being on the surface of said spherical crystal (2);
wherein:
said pair of electrodes are mutually separated such that an electrode (14) with one polarity and an electrode (15) with the other polarity are placed so that they are opposite each other with the center of said spherical crystal (2) interposed between the pair of electrodes (14,15) and such that the inflow/outflow of current with respect to said outside circuit occurs at the top and bottom of the spherical crystal.

2. The semiconductor device of claim 1, wherein:
said photovoltaic part (16) comprises:
a diffusion layer (6) which is formed near the surface of said spherical crystal (2); a pn junction (7) which is between said diffusion layer (6) and said semiconductor crystal (2).

3. The semiconductor device of claim 1 or 2, wherein:
said spherical semiconductor element (1) is a semiconductor photocatalyst;
said photocatalyst being arranged to generate an electrochemical reaction between said electrodes and an electrolyte solution when said photovoltaic part receives light.

4. The semiconductor device of claim 3, wherein:
said semiconductor device comprises a plurality of said spherical semiconductor elements (1);
wherein several spherical semiconductor elements (1) are arranged to be connected electrically in series via the photovoltage generated by said photovoltaic part (16) of said spherical semiconductor elements (1) which are in said electrolyte solution.

5. The semiconductor device of claim 3, wherein:
the surface of said spherical crystal (2), other that at said electrodes(14,15), is covered with an insulating coating (9) which is light transparent and has anti-reflective properties.

6. The semiconductor device of claim 5, wherein:
the surface of said insulating coating (9) is covered with a light-transparent coating (10) which is connected to an electrode (14) of one polarity;
said coating is made of metal oxide semiconductor which has a photocatalytic function.

7. The semiconductor device of claim 5, wherein:
the surface of an electrode (14) of one polarity and a portion of the entire surface of said insulating coating is covered with a light-transparent electrode coating (21);
said electrode coating (21) is made of metal oxide semiconductor which has a photocatalytic function.

8. The semiconductor device of claim 1 or 2, wherein:
said spherical crystal (2) is constructed from a semiconductor of Si or SiGe, Group III-V compound semiconductor or a chalcopyrite-type semiconductor.

9. The semiconductor device of claim 1 or 2, comprising:
a transparent case (222) which has a storage cavity (223) which stores a single spherical semiconductor element (221);
a pair of external electrodes (224, 226) which are partially inserted into both sides of said storage cavity (223) and hermetically seals said cavity (223);
said pair of external electrodes (224,226) being electrically connected to electrodes (14,15) of said spherical semiconductor element (221).

10. The semiconductor device of claim 1 or 2, comprising:
a semiconductor element array (231) in which a plurality of said spherical semiconductor elements (200) are electrically connected in series and are lined up in a single row;
a transparent case (232) which has a storage cavity (233) which stores said semiconductor element array (231);
a pair of external electrodes (243,236) which are partially inserted onto both sides of said storage cavity (233) of said case (232) and hermetically seals said cavity (233);
said pair of electrodes (234,236) being electrically connected to each of the electrodes (14,15) of said spherical semiconductor elements which are on both ends of said semiconductor array (231).

11. The semiconductor device of claim 10, wherein:
a plurality of storage cavities (243) are formed in parallel in said case (242);
said semiconductor element array (241) is placed in each storage cavity (243);
a pair of external electrodes (244,246) is placed on both ends of each storage cavity (243).

12. The semiconductor device of claim 1 or 2, comprising:
a semiconductor element array (241) in which a plurality of said spherical semiconductor elements (200) is electrically connected in series and is lined up in a single row;
a pair of external electrodes (244,246) being electrically connected to each of the electrodes (14,15) of said spherical semiconductor elements (200) which are on both ends of said semiconductor array (241);
a transparent case member (242) which covers the exterior of said semiconductor element array (241).

13. The semiconductor device of claim 12, wherein:
a plurality of semiconductor element arrays (241) are placed in parallel;
said plurality of semiconductor element arrays (241) are stored in an imbedded state inside said case member (242);
there are a plurality of pairs of electrodes (244, 246) corresponding to said plurality of semiconductor element arrays (241).

14. A semiconductor device, comprising:
independent spherical semiconductor elements (1), each comprising:
a spherical crystal (2) of p-type semiconductor or n-type semiconductor;
a diffusion layer (6) and a pn junction (7) formed near the surface of said spherical crystal (2);
a pair of electrodes (14,15) for the inflow/outflow of current with respect to an outside circuit, one electrode of the pair being on each side of said pn junction and each electrode being on the surface of said spherical crystal (2):
wherein:
said pair of electrodes are mutually separated such that an electrode (14) with one polarity and an electrode (15) with the other polarity are placed so that they are opposite each other with the center of said spherical crystal (2) interposed between the pair of electrodes (14,15) and such that the inflow/outflow of current with respect to said outside circuit occurs at the top and bottom of the spherical crystal.

15. The semiconductor device of claim 14, wherein:
an insulating coating (9) which is light transparent covers the surface of said spherical crystal, other than at said electrodes (14,15).

16. The semiconductor device of claim 15, comprising:
a transparent case (222) which has a storage cavity (223) which stores one of said spherical semiconductor elements (221);
a pair of external electrodes (224,226) which are partially inserted onto both ends of said storage cavity (223) and which hermetically seals said cavity (223);
said pair of external electrodes (224,226) being connected electrically to said electrodes (14,15) of each of said spherical semiconductor element (221).

17. The semiconductor device of claim 15, comprising:
a semiconductor element array (231) in which a plurality of said spherical semiconductor elements (200) are electrically connected in series and are lined up in a single row;
a transparent case (232) which has a storage cavity (233) which stores said semiconductor element array (231);
a pair of external electrodes (234,236) which are partially inserted onto both sides of said storage cavity (233) of said case (232) and hermetically seals said cavity (233);
said pair of external electrodes (234,236) being electrically connected to each of said electrodes (14,15) of said spherical semiconductor elements which are on both ends of said semiconductor array (231).

18. The semiconductor device of claim 17, wherein:
a plurality of storage cavities (243) are formed in parallel in said case (242);
a semiconductor element array (241) is placed in each storage cavity (243);
a pair of external electrodes (244,246) are placed on either end of each storage cavity (243).

19. The semiconductor device of claim 15, comprising:
a semiconductor element array (241) in which a plurality of said spherical semiconductor elements (200) is electrically connected in series and is lined up in a single row;
a pair of external electrodes (244,246) which are electrically connected to each of said electrodes (14,15) of said spherical semiconductor elements (200) which are on both ends of said semiconductor array (241);
a transparent case member (242) which covers the exterior of said semiconductor element array (241).

20. The semiconductor device of claim 19, wherein:
there are a plurality of rows of said semiconductor element arrays (241);
said plurality of semiconductor element arrays (241) are embedded in said transparent sheet-like case member (242);
there are a plurality of pairs of electrodes (244,246) which correspond to said plurality of semiconductor element arrays (241).

21. The semiconductor device of any one of the claims 16-20, wherein:
said semiconductor device is a device which has a light emitting function in which light is emitted by applying voltage to said spherical semiconductor elements (200).

22. The semiconductor device of claim 14,
said device functioning as a light emitting display panel (300), wherein:
a plurality of said spherical semiconductor elements (310,320,330) are placed to make a matrix of a plurality of rows and a plurality of columns;
a plurality of said spherical semiconductor elements (310,320,330) are housed in a case member which is transparent and panel-like;
light is emitted by selectively applying voltage to a pair or electrodes (315,316) of each individual semiconductor element (310,320,330).

23. The semiconductor device of claim 22, comprising:
a plurality of spherical semiconductor elements number 1 (310) which is capable of emitting red light;
a plurality of spherical semiconductor elements number 2 (320) which is capable of emitting green light;
a plurality of spherical semiconductor elements number 3 (330) which is capable of emitting blue light;
said spherical semiconductor elements numbers 1-3 being alternated in a cycle in the row direction of the matrix, and being alternated in a cycle in the column direction of the matrix.

24. The semiconductor device of claim 23, wherein:
each spherical crystal (2) in said spherical semiconductor elements numbers 1-3 are n-type GaAs semiconductors;
said diffusion layer (6) on said spherical crystal (311) contains Zn as the p-type dopant.

25. The semiconductor device of claim 24, wherein:
on the surface of said spherical crystal (311) of said spherical semiconductor element number 1, there is formed a coating (317) which contains a phosphor which converts infrared light to red light;
on the surface of said spherical crystal (311) of said spherical semiconductor element number 2, there is formed a coating (317) which contains a phosphor which converts infrared light to green light;
on the surface of said spherical crystal (311) of said spherical semiconductor element number 3, there is formed a coating (317) which contains a phosphor which converts infrared light to blue light.

## Patentansprüche

1. Halbleiterbauteil, welches umfasst:
ein unabhängiges kugelförmiges Halbleiterelement (1), welches umfasst:
einen kugelförmigen Kristall (2) eines p-Halbleiters oder n-Halbleiters;
- einen fotovoltaischen Teil (16), der auf der Oberfläche oder auf einem Bereich nahe der Oberfläche des kugelförmigen Kristalls (2) integriert ist,
- wobei der fotovoltaische Teil (16) in Verbindung mit dem kugelförmigen Kristall (2) Fotospannung erzeugt;
ein Paar Elektroden (14, 15) für das Hineinfließen/Herausfließen von elektrischem Strom bezüglich eines Außenkreislaufs, wobei eine Elektrode des Paars an jeder Seite des fotovoltaischen Teils (16) und jede Elektrode auf der Oberfläche des kugelförmigen Kristalls (2) angeordnet ist; wobei:
das Paar Elektroden voneinander getrennt ist, so dass eine Elektrode (14) mit einer Polarität und eine Elektrode (15) mit der anderen Polarität so angeordnet sind, dass sie sich gegenüberliegen, wobei die Mitte des kugelförmigen Kristalls (2) zwischen dem Paar Elektroden (14, 15) liegt, und dass das Hineinfließen/Herausfließen von elektrischem Strom bezüglich des Außenkreislaufs am oberen und unteren Ende des kugelförmigen Kristalls erfolgt.

2. Halbleiterbauteil nach Anspruch 1, **dadurch gekennzeichnet, dass**:
der fotovoltaische Teil (16) umfasst:
eine nahe der Oberfläche des kugelförmigen Kristalls (2) ausgebildete Diffusionsschicht (6);
einen pn-Übergang (7), der sich zwischen der Diffusionsschicht (6) und dem Halbleiterkristall (2) befindet.

3. Halbleiterbauteil nach Anspruch 1 oder 2, **dadurch gekennzeichnet, dass**:
das kugelförmige Halbleiterelement (1) ein Halbleiter-Photokatalysator ist;
wobei der Photokatalysator so angeordnet ist, dass er eine elektrochemische Reaktion zwischen den Elektroden und einer Elektrolytlösung erzeugt, wenn der fotovoltaische Teil Licht empfängt.

4. Halbleiterbauteil nach Anspruch 3, **dadurch gekennzeichnet, dass**:
das Halbleiterbauteil mehrere der kugelförmigen Halbleiterelemente (1) umfasst;
wobei mehrere kugelförmige Halbleiterelemente (1) angeordnet sind, um mittels der von dem fotovoltaischen Teil (16) der kugelförmigen Halbleiterelemente (1), die sich in der Elektrolytlösung befinden, erzeugten Fotospannung elektrisch in Reihe verbunden zu werden.

5. Halbleiterbauteil nach Anspruch 3, **dadurch gekennzeichnet, dass**:
die Oberfläche des kugelförmigen Kristalls (2), außer an den Elektroden (14, 15), mit einer Isolierschicht (9) bedeckt ist, die lichtdurchlässig ist und Antireflexionseigenschaften aufweist.

6. Halbleiterbauteil nach Anspruch 5, **dadurch gekennzeichnet, dass**:
die Oberfläche der Isolierschicht (9) mit einer lichtdurchlässigen Beschichtung (10), die an eine Elektrode (14) einer Polarität angeschlossen ist, bedeckt ist;
wobei die Beschichtung aus einem Metalloxidhalbleiter gefertigt ist, der eine fotokatalytische Funktion hat.

7. Halbleiterbauteil nach Anspruch 5, **dadurch gekennzeichnet, dass**:
die Oberfläche einer Elektrode (14) einer Polarität und ein Teil der gesamten Oberfläche der Isolierschicht mit einer lichtdurchlässigen Elektrodenbeschichtung (21) bedeckt ist;
wobei die Elektrodenbeschichtung (21) aus einem Metalloxidhalbleiter gefertigt ist, der eine fotokatalytische Funktion hat

8. Halbleiterbauteil nach Anspruch 1 oder 2, **dadurch gekennzeichnet, dass**:
der kugelförmige Kristall (2) aus einem Si- oder SiGe-Halbleiter, einem Verbindungshalbleiter der Gruppe III-V oder einem Chalcopyrit-Halbleiter gebildet ist.

9. Halbleiterbauteil nach Anspruch 1 oder 2, welches umfasst:
ein transparentes Gehäuse (222), welches einen Aufnahmehohlraum (223) aufweist, welcher ein einzelnes kugelförmiges Halbleiterelement (221) aufnimmt;
ein Paar Außenelektroden (224, 226), welche in beide Seiten des Aufnahmehohlraums (223) teilweise eingeführt sind und welches den Hohlraum (223) hermetisch abdichtet;
wobei das Paar Außenelektroden (224, 226) mit den Elektroden (14, 15) des kugelförmigen Halbleiterelements (221) elektrisch verbunden ist.

10. Halbleiterbauteil nach Anspruch 1 oder 2, welches umfasst,
eine Halbleiterlelementanordnung (231), bei welcher mehrere der kugelförmigen Halbleiterelemente (200) elektrisch in Reihe geschaltet sind und in einer einzigen Reihe angeordnet sind;
ein transparentes Gehäuse (232), welches einen Aufnahmehohlraum (233) aufweist, welcher die Halbleiterelementanordnung (231) aufnimmt;
ein Paar Außenelektroden (243, 236), welche in beide Seiten des Aufnahmehohlraums (233) des Gehäuses (232) teilweise eingeführt sind und welches den Hohlraum (233) hermetisch abdichtet;
wobei das Paar Außenelektroden (234, 236) mit jeder der Elektroden (14, 15) der kugelförmigen Halbleiterelemente, welche sich an beiden Enden der Halbleiteranordnung (231) befinden, elektrisch verbunden ist.

11. Halbleiterbauteil nach Anspruch 10, **dadurch gekennzeichnet, dass**
mehrere Aufnahmehohlräume (243) parallel in dem Gehäuse (242) ausgebildet sind;
in jedem Aufnahmehohlraum (243) eine Halbleiterelementanordnung (241) positioniert ist;
ein Paar Außenelektroden (244, 246) an beiden Enden jedes Aufnahmehohlraums (243) positioniert ist.

12. Halbleiterbauteil nach Anspruch 1 oder 2, welches umfasst:
eine Halbleiterelementanordnung (241), bei welcher mehrere der kugelförmigen Halbleiterelemente (200) elektrisch in Reihe geschaltet sind und in einer einzigen Reihe angeordnet sind;
ein Paar Außenelektroden (244, 246), welches mit jeder der Elektroden (14, 15) der kugelförmigen Halbleiterelemente (200), welche sich an beiden Enden der Halbleiteranordnung (241) befinden, elektrisch verbunden ist;
ein transparentes Gehäuseteil (242), welches das Äußere der Halbleiterelementanordnung (241) bedeckt.

13. Halbleiterbauteil nach Anspruch 12, **dadurch gekennzeichnet, dass**:
mehrere Reihen der Halbleiterelementanordnungen (241) parallel angeordnet sind;
diese mehreren Halbleiterelementanordnungen (241) in dem Gehäuseteil (242) in eingebettetem Zustand gelagert sind;
es mehrere Elektrodenpaare (244, 246) gibt, welche den mehreren Halbleiterelementanordnungen (241) entsprechen.

14. Halbeiterbauteil, welches umfasst:
unabhängige kugelförmige Halbleiterelemente (1), wobei jedes umfasst:
einen kugelförmigen Kristall (2) eines p-Halbleiters oder n- Halbleiters;
eine Diffusionsschicht (6) und einen nahe der Oberfläche des kugelförmigen Kristalls (2) ausgebildeten pn-Übergang (7);
ein Paar Elektroden (14, 15) für das Hineinfließen/Herausfließen von elektrischem Strom bezüglich eines Außenkreislaufs, wobei sich eine Elektrode des Paars auf jeder Seite des pn-Übergangs und jede Elektrode auf der Oberfläche des kugelförmigen Kristalls (2) befindet:
wobei:
das Paar Elektroden voneinander getrennt sind, so dass eine Elektrode (14) einer Polarität und eine Elektrode (15) der anderen Polarität so angeordnet sind, dass sie sich gegenüberliegen, wobei die Mitte des kugelförmigen Kristalls (2) zwischen dem Paar von Elektroden (14, 15) liegt, und dass das Hineinfließen/Herausfließen von elektrischem Strom bezüglich des Außenkreislaufs am oberen und unteren Ende des kugelförmigen Kristalls erfolgt.

15. Halbleiterbauteil nach Anspruch 14, **dadurch gekennzeichnet, dass**:
eine Isolierschicht (9), die lichtdurchlässig ist, die Oberfläche des kugelförmigen Kristalls, außer an den Elektroden (14, 15), bedeckt.

16. Halbleiterbauteil nach Anspruch 15, welches umfasst:
ein transparentes Gehäuse (222), welches einen Aufnahmehohlraum (223) aufweist, welcher eines der kugelförmigen Halbleiterelemente (221) aufnimmt;
ein Paar Außenelektroden (224, 226), welche in beide Enden des Aufnahmehohlraums (223) teilweise eingeführt sind und welches den Hohlraum (223) hermetisch abdichtet;
wobei das Paar Außenelektroden (224, 226) mit den Elektroden jedes der kugelförmigen Halbleiterelemente (221) elektrisch verbunden ist.

17. Halbleiterbauteil nach Anspruch 15, welches umfasst:
eine Halbleiterelementanordnung (231), bei welcher mehrere der kugelförmigen Halbleiterelemente (200) elektrisch in Reihe geschaltet sind und in einer einzigen Reihe angeordnet sind;
ein transparentes Gehäuse (232), welches einen Aufnahmehohlraum (233) aufweist, welcher die Halbleiterelementanordnung (231) aufnimmt;
ein Paar Außenelektroden (243, 236), welche in beide Seiten des Aufnahmehohlraums (233) des Gehäuses (232) teilweise eingeführt sind und welches den Hohlraum (233) hermetisch abdichtet;
wobei das Paar Außenelektroden (234, 236) mit jeder der Elektroden (14, 15) der kugelförmigen Halbleiterelemente, welche sich an beiden Enden der Halbleiteranordnung (231) befinden, elektrisch verbunden ist.

18. Halbleiterbauteil nach Anspruch 17, **dadurch gekennzeichnet, dass**:
mehrere Aufnahmehohlräume (243) parallel in dem Gehäuse (242) ausgebildet sind;
in jedem Aufnahmehohlraum (243) eine Halbleiterelementanordnung (241) positioniert ist;
ein Paar Außenelektroden (244, 246) an jedem Ende jedes Aufnahmehohlraums (243) positioniert sind.

19. Halbleiterbauteil nach Anspruch 15, welches umfasst:
eine Halbleiterelementanordnung (241), bei welcher mehrere der kugelförmigen Halbleiterelemente (200) elektrisch in Reihe geschaltet sind und in einer einzigen Reihe angeordnet sind;
ein Paar Außenelektroden (244, 246), welche mit jeder der Elektroden (14, 15) der kugelförmigen Halbleiterelemente (200), welche sich an beiden Enden der Halbleiteranordnung (241) befinden, elektrisch verbunden sind;
ein transparentes Gehäuseteil (242), welches das Äußere der Halbleiterelementanordnung (241) bedeckt.

20. Halbleiterbauteil nach Anspruch 19, **dadurch gekennzeichnet, dass**:
es mehrere Reihen der Halbleiterelementanordnungen (241) gibt;
diese mehreren Halbleiterelementanordnungen (241) in dem transparenten, plattenartigen Gehäuseteil (242) eingebettet sind;
es mehrere Elektrodenpaare (244, 246) gibt, welche den mehreren Halbleiterelementanordnungen (241) entsprechen.

21. Halbleiterbauteil nach einem der Ansprüche 16 bis 20, **dadurch gekennzeichnet, dass**:
das Halbleiterbauteil ein Bauteil ist, welches eine Licht emittierende Funktion aufweist, bei der Licht durch Anlegen von Spannung an den kugelförmigen Halbleiterlelementen (200) emittiert wird.

22. Halbleiterbauteil nach Anspruch 14, wobei das Bauteil als Licht emittierendes Anzeigefeld (300) fungiert, **dadurch gekennzeichnet, dass**:
mehrere der kugelförmigen Halbleiterelemente (310, 320, 330) angeordnet werden, um eine Matrix aus mehreren Reihen und mehreren Spalten zu bilden;
die mehreren kugelförmigen Halbleiterelemente (310, 320, 330) in einem Gehäuseteil aufgenommen sind, welches transparent und plattenartig ist;
Licht durch wahlweises Anlegen von Spannung an einem Elektrodenpaar (315, 316) jedes einzelnen Halbleiterelements (310, 320, 330) emittiert wird.

23. Halbleiterbauteil nach Anspruch 22, welches umfasst:
mehrere kugelförmige Halbleiterelemente Nummer 1 (310), welche rotes Licht emittieren können;
mehrere kugelförmige Halbleiterelemente Nummer 2 (320), welche grünes Licht emittieren können;
mehrere kugelförmige Halbleiterelemente Nummer 3 (330), welche blaues Licht emittieren können;
wobei die kugelförmigen Halbleiterelemente Nummer 1 bis 3 zyklisch in der Reihenrichtung der Matrix abwechseln und zyklisch in der Spaltenrichtung der Matrix abwechseln.

24. Halbleiterbauteil nach Anspruch 23, **dadurch gekennzeichnet, dass**:
jeder kugelförmige Kristall (2) in den kugelförmigen Halbleiterelementen Nummer 1 - 3 ein GaAs-Halbleiter des n-Typs ist;
die Diffusionsschicht (6) auf dem kugelförmigen Kristall (311) Zn als p-Dotierungsmittel enthält.

25. Halbleiterbauteil nach Anspruch 24, **dadurch gekennzeichnet, dass**:
an der Oberfläche des kugelförmigen Kristalls (311) des kugelförmigen Halbleiterelements Nummer 1 eine Beschichtung (317) ausgebildet ist, welche einen Phosphor enthält, welcher Infrarotlicht in rotes Licht umwandelt;
an der Oberfläche des kugelförmigen Kristalls (311) des kugelförmigen Halbleiterelements Nummer 2 eine Beschichtung (317) ausgebildet ist, welche einen Phosphor enthält, welcher Infrarotlicht in grünes Licht umwandelt;
an der Oberfläche des kugelförmigen Kristalls (311) des kugelförmigen Halbleiterelements Nummer 3 eine Beschichtung (317) ausgebildet ist, welche einen Phosphor enthält, welcher Infrarotlicht in blaues Licht umwandelt.

## Revendications

1. Dispositif à semi-conducteur, comprenant :
un élément sphérique à semi-conducteur indépendant (1), comprenant :
un cristal sphérique (2) à semi-conducteur de type p ou à semi-conducteur de type n ;
une partie photovoltaïque (16) qui est incorporée à la surface ou à une zone près de la surface dudit cristal sphérique (2) ;
ladite partie photovoltaïque (16) générant une tension photoélectrique en association avec ledit cristal sphérique (2) ;
une paire d'électrodes (14, 15) pour l'entrée/la sortie de courant par rapport à un circuit extérieur, une électrode de la paire se trouvant de chaque côté de la partie photovoltaïque (16), et chaque électrode étant sur la surface dudit cristal sphérique (2) ;
dans lequel :
les électrodes de ladite paire d'électrodes (14, 15) sont mutuellement séparées de telle sorte qu'une électrode (14) avec une polarité et une électrode (15) avec l'autre polarité sont placées de façon à être opposées l'une à l'autre, avec le centre du cristal sphérique (2) interposé entre elles de telle sorte que l'entrée/la sortie de courant par rapport audit circuit extérieur se produit en haut et en bas du cristal sphérique.

2. Dispositif à semi-conducteur selon la revendication 1, dans lequel :
ladite partie photovoltaïque (16) comprend :
une couche de diffusion (6) formée près de la surface dudit cristal sphérique (2) ;
une jonction pn (7) qui est située entre ladite couche de diffusion (6) et ledit cristal à semi-conducteur (2).

3. Dispositif à semi-conducteur selon l'une des revendications 1 et 2, dans lequel :
ledit élément sphérique à semi-conducteur (1) est un photocatalyseur à semi-conducteur ;
ledit photocatalyseur étant agencé pour générer une réaction électrochimique entre lesdites électrodes et une solution électrolytique, lorsque ladite partie photovoltaïque reçoit de la lumière.

4. Dispositif à semi-conducteur de la revendication 3, dans lequel :
ledit dispositif à semi-conducteur comprend une pluralité desdits éléments sphériques à semi-conducteur (1) ;
dans lequel plusieurs éléments sphériques à semi-conducteur (1) sont agencés pour être connectés électriquement en série via la tension photovoltaïque générée par ladite partie photovoltaïque (16) desdits éléments sphériques à semi-conducteur (1) qui sont dans ladite solution électrolytique.

5. Dispositif à semi-conducteur selon la revendication 3, dans lequel :
la surface dudit cristal sphérique, ailleurs qu'aux-dites électrodes, est couverte par un revêtement isolant qui est transparent à la lumière et qui a des propriétés antiréfléchissantes.

6. Dispositif à semi-conducteur selon la revendication 5, dans lequel :
la surface dudit revêtement isolant est couverte par une couche transparente à la lumière qui est connectée à une électrode d'une polarité ;
ladite couche est faite de semi-conducteur à oxyde métallique qui a une fonction photocatalytique.

7. Dispositif à semi-conducteur selon la revendication 5, dans lequel :
la surface d'une électrode d'une polarité et une partie de la surface totale dudit revêtement isolant est couverte par un revêtement d'électrode transparent à la lumière ;
ledit revêtement d'électrode est fait de semi-conducteur à oxyde métallique qui a une fonction photocatalytique.

8. Dispositif à semi-conducteur selon la revendication 1 ou 2, dans lequel :
ledit cristal sphérique (2) est construit à partir d'un semi-conducteur de Si ou de SiGe, d'un semi-conducteur composé de Groupe III-V ou d'un semi-conducteur de type chalcopyrite.

9. Dispositif à semi-conducteur selon la revendication 1 ou 2, comprenant :
un boîtier transparent (222) qui possède une cavité de stockage (223) qui stocke l'un desdits éléments sphériques à semi-conducteur (221) ;
une paire d'électrodes externes (224, 226) qui est insérée partiellement de chaque côté de ladite cavité de stockage (223) et qui scelle de façon hermétique ladite cavité (223) ;
ladite paire d'électrodes externes (224, 226) étant connectée électriquement à ladite paire d'électrodes (14, 15) dudit élément sphérique à semi-conducteur (221).

10. Dispositif à semi-conducteur selon la revendication 1 ou 2, comprenant :
une matrice d'éléments à semi-conducteur (231) dans laquelle une pluralité desdits éléments sphériques à semi-conducteur (200) sont connectés électriquement en série et alignés en une seule rangée ;
un boîtier transparent (232) qui a une cavité de stockage (233) qui stocke ladite matrice d'éléments à semi-conducteur (231) ;
une paire d'électrodes externes (234, 236) qui est insérée partiellement de chaque côté de ladite cavité de stockage (233) dudit boîtier (232) et qui scelle de façon hermétique ladite cavité (233) ;
ladite paire d'électrodes externes (234, 236) étant connectée électriquement à chacune desdites électrodes (14, 15) desdits éléments sphériques à semi-conducteur qui sont sur les deux extrémités de ladite matrice à semi-conducteur (231).

11. Dispositif à semi-conducteur selon la revendication 10, dans lequel :
une pluralité de cavités de stockage (243) sont formées en parallèle dans ledit boîtier (242);
ladite matrice d'éléments à semi-conducteur (241) est placée dans chaque cavité de stockage (243) ;
une paire d'électrodes externes (244, 246) est placée à chaque extrémité de chaque cavité de stockage (243).

12. Dispositif à semi-conducteur selon la revendication 1 ou 2, comprenant :
une matrice d'éléments à semi-conducteur (241) dans laquelle une pluralité desdits éléments sphériques à semi-conducteur (200) est connectée électriquement en série et alignée en une seule rangée ;
une paire d'électrodes externes (244, 246) qui est connectée électriquement à chacune desdites électrodes (14, 15) desdits éléments sphériques à semi-conducteur (200) qui sont aux deux extrémités de ladite matrice à semi-conducteur (241) ;
un élément de boîtier transparent (242) qui couvre l'extérieur de ladite matrice d'éléments à semi-conducteur (241).

13. Dispositif à semi-conducteur selon la revendication 12, dans lequel :
une pluralité de rangées desdites matrices d'éléments à semi-conducteur (241) sont placées en parallèle ;
ladite pluralité de matrices d'éléments à semi-conducteur (241) sont stockées dans un état noyé dans ledit élément de boîtier (242) ;
il y a une pluralité de paires d'électrodes (244, 246) qui correspond à ladite pluralité de matrices d'éléments à semi-conducteur (241).

14. Dispositif à semi-conducteur, comprenant :
des éléments sphériques à semi-conducteur indépendants (1), comprenant chacune :
un cristal sphérique (2) à semi-conducteur de type p ou à semi-conducteur de type n ;
une couche de diffusion (6) et une jonction pn (7) formée près de la surface dudit cristal sphérique (2) ;
une paire d'électrodes (14, 15) pour l'entrée/la sortie de courant par rapport à un circuit extérieur, une électrode de la paire se trouvant de chaque côté de la jonction pn, et chaque électrode étant sur la surface dudit cristal sphérique (2) :
dans lequel :
ladite paire d'électrodes (14, 15) sont mutuellement séparées de telle sorte qu'une électrode (14) avec une polarité et une électrode (15) avec l'autre polarité sont placées de façon à être opposées l'une à l'autre, avec le centre du cristal sphérique (2) interposé entre elles de telle sorte que l'entrée/la sortie de courant par rapport audit circuit extérieur se produit en haut et en bas du cristal sphérique.

15. Dispositif à semi-conducteur selon la revendication 14, dans lequel :
un revêtement isolant (9) qui est transparent à la lumière recouvre la surface dudit cristal sphérique, ailleurs qu'auxdites électrodes (14, 15).

16. Dispositif à semi-conducteur selon la revendication 15, comprenant :
un boîtier transparent (222) qui possède une cavité de stockage (223) qui stocke l'un desdits éléments sphériques à semi-conducteur (221) ;
une paire d'électrodes externes (224, 226) qui est insérée partiellement de chaque côté de ladite cavité de stockage (223) et qui scelle de façon hermétique ladite cavité (223) ;
ladite paire d'électrodes externes (224, 226) étant connectée électriquement à ladite paire d'électrodes (14, 15) dudit élément sphérique à semi-conducteur (221).

17. Dispositif à semi-conducteur selon la revendication 15, comprenant :
une matrice d'éléments à semi-conducteur (231) dans laquelle une pluralité desdits éléments sphériques à semi-conducteur (200) sont connectés électriquement en série et alignés en une seule rangée ;
un boîtier transparent (232) qui a une cavité de stockage (233) qui stocke ladite matrice d'éléments à semi-conducteur (231) ;
une paire d'électrodes externes (234, 236) qui est insérée partiellement de chaque côté de ladite cavité de stockage (233) dudit boîtier (232) et qui scelle de façon hermétique ladite cavité (233) ;
ladite paire d'électrodes externes (234, 236) étant connectée électriquement à chacune desdites électrodes (14, 15) desdits éléments sphériques à semi-conducteur qui sont sur les deux extrémités de ladite matrice à semi-conducteur (231).

18. Dispositif à semi-conducteur selon la revendication 17, dans lequel :
une pluralité de cavités de stockage (243) sont formées en parallèle dans ledit boîtier (242);
ladite matrice d'éléments à semi-conducteur (241) est placée dans chaque cavité de stockage (243) ;
une paire d'électrodes externes (244, 246) est placée à chaque extrémité de chaque cavité de stockage (243).

19. Dispositif à semi-conducteur selon la revendication 15, comprenant :
une matrice d'éléments à semi-conducteur (241) dans laquelle une pluralité desdits éléments sphériques à semi-conducteur (200) est connectée électriquement en série et alignée en une seule rangée ;
une paire d'électrodes externes (244, 246) qui est connectée électriquement à chacune desdites électrodes (14, 15) desdits éléments sphériques à semi-conducteur (200) qui sont aux deux extrémités de ladite matrice à semi-conducteur (241) ;
un élément de boîtier transparent (242) qui couvre l'extérieur de ladite matrice d'éléments à semi-conducteur (241).

20. Dispositif à semi-conducteur selon la revendication 19, dans lequel :
il y a une pluralité de rangées desdites matrices d'éléments à semi-conducteur (241) ;
ladite pluralité de matrices d'éléments à semi-conducteur (241) sont noyées dans ledit élément de boîtier (242) ;
il y a une pluralité de paires d'électrodes (244, 246) qui correspond à ladite pluralité de matrices d'éléments à semi-conducteur (241).

21. Dispositif à semi-conducteur selon l'une des revendications 16 à 20, dans lequel :
ledit dispositif est un dispositif qui a une fonction d'émission de lumière dans lequel la lumière est émise en appliquant une tension auxdits éléments sphériques à semi-conducteur (200).

22. Dispositif à semi-conducteur selon la revendication 14, dans lequel :
ledit dispositif fonctionne en tant que panneau d'affichage émetteur de lumière (300), dans lequel :
une pluralité desdits éléments sphériques à semi-conducteur (310, 320, 330) sont placés pour faire une matrice d'une pluralité de rangées et d'une pluralité de colonnes ;
ladite pluralité d'éléments sphériques à semi-conducteur (310, 320, 330) sont logés dans un élément de boîtier qui est transparent et analogue à un panneau ;
de la lumière est émise en appliquant sélectivement une tension à une paire d'électrodes (315, 316) de chaque élément à semi-conducteur individuel (310, 320, 330).

23. Dispositif à semi-conducteur selon la revendication 22, comprenant :
une pluralité d'éléments sphériques à semi-conducteur numéro 1 qui est capable d'émettre de la lumière rouge ;
une pluralité d'éléments sphériques à semi-conducteur numéro 2 qui est capable d'émettre de la lumière verte ;
une pluralité d'éléments sphériques à semi-conducteur numéro 3 qui est capable d'émettre de la lumière bleue ;
lesdits éléments sphériques à semi-conducteur numéros 1 à 3 étant alternés en un cycle dans la direction des rangées de la matrice, et étant alternés en un cycle dans la direction des colonnes de la matrice.

24. Dispositif à semi-conducteur selon la revendication 23, dans lequel :
chaque cristal sphérique dans lesdits éléments sphériques à semi-conducteur numéros 1 à 3 sont des semiconducteurs de GaAs de type n ;
ladite couche de diffusion sur ledit cristal sphérique contient du Zn en tant que dopant de type p.

25. Dispositif à semi-conducteur selon la revendication 24, dans lequel :
sur la surface dudit cristal sphérique dudit élément sphérique à semi-conducteur numéro 1 est formé un revêtement qui contient une substance fluorescente qui convertit la lumière infrarouge en lumière rouge ;
sur la surface dudit cristal sphérique dudit élément sphérique à semi-conducteur numéro 2 est formé un revêtement qui contient une substance fluorescente qui convertit la lumière infrarouge en lumière verte ;
sur la surface dudit cristal sphérique dudit élément sphérique à semi-conducteur numéro 3 est formé un revêtement qui contient une substance fluorescente qui convertit la lumière infrarouge en lumière bleue.
